# EUROPÄISCHE PATENTSCHRIFT

(11) **EP 2 591 646 B1**
(45) Veröffentlichungstag und Bekanntmachung des Hinweises auf die Patenterteilung: **24.12.2014**
(21) Anmeldenummer: 11706742.1
(22) Anmeldetag: 10.02.2011
(51) Int. Cl.: F25D 31/00, H05K 7/20

(54) **SYSTEM UND VERFAHREN ZUR KÜHLUNG EINER RECHENANLAGE**
SYSTEM AND METHOD FOR COOLING A COMPUTER SYSTEM
SYSTÈME ET PROCÉDÉ DE REFROIDISSEMENT D'UN ORDINATEUR

(30) Priorität: 06.07.2010 DE 102010026297
(43) Veröffentlichungstag der Anmeldung: 15.05.2013
(73) Patentinhaber: Sam Technologies GmbH, 07743 Jena (DE)
(72) Erfinder: HEILAND, Peter, 65479 Raunheim (DE); BIRKNER, Andreas, 07743 Jena (DE)
(74) Vertreter: Blumbach Zinngrebe
(86) Internationale Anmeldenummer: PCT/EP2011/000617
(87) Internationale Veröffentlichungsnummer: WO 2012/003895

(56) Entgegenhaltungen:
- EP-A2- 2 091 314
- JP-A- 11 257 883
- US-A1- 2007 283 716
- US-A1- 2009 219 681
- US-B1- 7 508 666

## Beschreibung

### Gebiet der Erfindung

Die Erfindung betrifft ein System und Verfahren zur Kühlung einer Rechenanlage, insbesondere zur Kühlung einer Server-Farm.

### Hintergrund der Erfindung

Rechenanlagen, insbesondere eine Vielzahl von Racks umfassende Server-Farmen, erzeugen im Betrieb große Wärmemengen. So kommt eine Server-Farm in der Regel auf eine reine Heizleistung von mehreren Kilowatt. Um diese großen Wärmemengen abzuführen, werden in der Regel Klimaanlagen verwendet, deren Betrieb sehr energieintensiv ist.

Es sind in der Praxis zwar Ansätze bekannt, mit denen versucht wird, die Abwärme einer Rechenanlage zur Beheizung eines Gebäudes zu nutzen. Vielfach ist ein derartiger Ansatz aber mangels beheizbarer Gebäudeflächen in der Nähe nicht möglich und auch, je nach Klimazone und Jahreszeit, nicht geeignet für eine hinreichende Kühlung einer in einem Gebäude vorhandenen Rechenanlage zu sorgen. Weiterhin wird im Sommer vielfach keine Heizenergie zur Gebäudeheizung benötigt.

Es wird geschätzt, dass die für Server-Farmen benötigte Energie in den nächsten Jahren auf 100 GWh oder mehr anwachsen wird, wobei bis zu 40% dieser Energie allein der Kühlung zugerechnet wird.

Herkömmliche Rechenanlagen werden in der Regel über die Klimatisierung des Raumes gekühlt, wobei die einzelnen Rechner über einen Lüfter Wärme an die Umgebungsluft abgeben.

Es gibt aber auch neuere Ansätze, bei denen die Racks einer Rechenanlage über eine Flüssigkeit gekühlt werden, wobei über einen in dem Rack integrierten oder einen an das Rack angrenzenden Wärmetauscher die Kühlluft der Racks ihre Wärmeenergie an eine außerhalb des Racks zu kühlende Flüssigkeit abgeben.

Ein weiterer Ansatz ist es, die Wärmeenergie über eine Flüssigkeitskühlung direkt von den Prozessoren abzuführen. Unter einer direkten Abführung der Wärmeenergie wird verstanden, dass flüssigkeitsgekühlte Kühlkörper in direktem Kontakt mit den Prozessoren stehen. Diese Technik hat zwar den Vorteil, dass auf einem kleinen lokalen Volumen ein Großteil der entstehenden Hitze abgeführt werden kann, ist aber in der Praxis zumindest nicht großtechnisch umgesetzt, was möglicherweise darauf zurückzuführen ist, dass die mit der Flüssigkeitskühlung von Prozessoren verbundenen technischen Schwierigkeiten, wie hinreichende Sicherung der Dichtheit, noch in keinem sinnvollen Verhältnis zu deren Nutzen stehen.

Im Zuge weiter steigender Rechenleistungen auf immer kleinerem Raum ist davon auszugehen, dass auch die Kühlleistung und der damit verbundene Energieverbrauch ansteigen wird.

### Aufgabe der Erfindung

Der Erfindung liegt demgegenüber die Aufgabe zugrunde, den Energiebedarf einer herkömmlichen Kühlung für Rechenanlagen zu senken.

### Beschreibung der Erfindung

Die Aufgabe der Erfindung wird bereits durch ein System zur Kühlung einer Rechenanlage, eine Rechenanlage, sowie durch ein Verfahren zur Kühlung einer Rechenanlage nach einem der unabhängigen Ansprüche gelöst.

Die Erfindung betrifft ein System zur Kühlung einer Rechenanlage, welches eine Kältemaschine umfasst. Unter einer Kältemaschine wird gemeinhin eine Vorrichtung verstanden, die der Erzeugung von Kälte dient, also einer Temperatur, die geringer ist als die Umgebungstemperatur.

Die Erfindung bezieht sich insbesondere auf Kompressionskältemaschinen, also Kältemaschinen mit einem mechanischen Verdichter über den das Kältemittel verflüssigt wird, welches sodann im Kaltteil der Kältemaschine verdampfen kann, wobei es sich abkühlt und die Kühlleistung erzeugt.

Die Erfindung bezieht sich aber auch auf sämtliche anderen Arten von Kältemaschinen, insbesondere Sorptionskältemaschinen, wie Adsorptions- oder Absorptionskältemaschinen, insbesondere auf die im Prinzip der absorptiven Trocknung (DCS) arbeitende Kältemaschinen, auf dem magnetokalorischen Effekt arbeitende Kältemaschinenen, mit Peltier-Elementen arbeitende Kältemaschinen, geothermisch arbeitende Kältemaschinen, Dampfstrahl-Kältemaschinen, nach dem Joule-Thomson-Effekt arbeitende Kältemaschinen und/oder auf dem Prinzip der Verdunstungskühlung arbeitende Kältemaschinen.

Gemäß der Erfindung umfasst die Rechenanlage zumindest einen ersten und einen zweiten Kühlkreislauf, wobei der erste Kühlkreislauf über eine Flüssigkeit und/oder über Wärmeleitung betreibbar ist. Beim ersten Kühlkreislauf handelt es sich somit nicht um einen luftbasierten Kühlkreislauf. Vielmehr erfolgt die Kühlung mittels einer Flüssigkeit, wie beispielsweise Wasser, oder mittels Wärmeleitung, wobei die Wärme an den Wärme erzeugenden Komponenten direkt über Bauteile mit guter Wärmeleitung abgeführt wird. Unter Wärmeleitung wird auch die Verwendung von Heat-Pipes verstanden, welche die Wärme aufgrund eines Kondensations- und Verdampfungsprozesses schneller abführen. Weiter ist gemäß der Erfindung zumindest der zweite Kühlkreislauf, welcher in der Regel ein luftbasierter Kühlkreislauf ist, mit einem Kaltteil der Kältemaschine verbunden.

Die Erfindung sieht insbesondere vor, Komponenten, die mit hoher Temperatur betrieben werden, insbesondere die Prozessorkühlung, mit einem flüssigkeitsbasierten oder auf Wärmeleitung basierten Kühlkreislauf zu kühlen. Aufgrund der hohen Temperaturen, insbesondere einer Temperatur von über 50°C, mit welcher diese Komponenten betrieben werden können, ist es vielfach möglich, die entstehende Wärme ohne die Verwendung einer Kältemaschine nach außen abzuführen oder als Nutzwärme für Heizung und Warmwasser weiterzuverwenden.

Die Prozessorkühlung im Sinne der Erfindung kann nicht nur die Hauptprozessoren des Rechensystems enthalten, sondern die Prozessorkühlung kann auch weitere Prozessoren oder elektronische Bauteile wie Speicherschaltkreise, Festplatten, Chipsets, Leistungsbauteile der Stromversorgung umfassen, welche wiederum in verschiedenen Komponenten des Rechenanlage wie den Server-Racks, Telekommunikationseinrichtungen, Stromversorgungen, Datenspeichern und weiteren Komponenten der Rechenanlage enthalten sind.

Die Rechenanlage im Sinne der Erfindung umfasst mithin nicht nur die die Server, sondern weitere Komponenten zur Stromversorgung, insbesondere Netzteile und Notstromversorgungen, Kommunikationsmodule, Datenspeicher etc..

Über den zweiten, in der Regel als Luftkühlkreislauf ausgebildeten Kühlkreislauf, welcher mit dem Kaltteil einer Kältemaschine verbunden ist, braucht nunmehr nur noch die Energie abgeführt zu werden, welche über den ersten Kühlkreislauf, der mit einer wesentlich höheren Temperatur betrieben wird, nicht abgeführt werden kann (oder nicht abgeführt wird). Der zweite Kühlkreislauf arbeitet in der Regel mit einer Vorlauftemperatur, welche 20 °C nicht wesentlich übersteigt, insbesondere maximal 20 °C.

Insbesondere kann dieser Kühlkreislauf als geschlossenes System ausgebildet sein, an welchem die Komponenten der Rechenanlage angeschlossen sind. Da die nunmehr über die relativ ineffizient arbeitende Kältemaschine abzuführende Wärmemenge im Verhältnis gering ist, kann die für das System benötigte Kühlenergie erheblich reduziert werden.

Die Erfindung betrifft also ein System zur Kühlung einer Rechenanlage mit mehreren Kühlkreisläufen, insbesondere mindestens zwei Kühlkreisläufen, wobei durch die Unterteilung der insgesamt abzuführenden thermischen Energie durch mehrere Kühlkreisläufe eine Aufteilung in verschiedenen Temperaturen dieser einzelnen Kühlkreisläufe erfolgt, was es ermöglicht, aus der insgesamt abzuführenden thermischen Energie eine Teilmenge oder mehrere Teilmengen dieser thermischen Energie auf Grund der jeweiligen Temperatur besonders effizient zu kühlen oder einer weiteren Nutzung zuzuführen.

Bei einer Weiterbildung der Erfindung ist ein Rücklauf des ersten Kühlkreislaufs sowohl mit einem Wärmetauscher als auch mit dem Kaltteil der Kältemaschine verbindbar. Der Wärmetauscher kann beispielsweise extern an einem Gebäude angebracht sein. Unter einem Wärmetauscher im Sinne der Erfindung wird aber auch die Weiterverwendung des Kühlfluids beispielsweise zur Erzeugung von Nutzwärme verstanden. Dadurch, dass der erste Kühlkreislauf, insbesondere die Prozessorkühlung, sowohl mit einem insbesondere externen Wärmetauscher als auch mit dem Kaltteil der Kältemaschine verbindbar ist, ist es möglich, insbesondere über ein Wegeventil, variabel die Wärmemenge zu verteilen, welche über die Kältemaschine und welche über den Wärmetauscher abgeführt werden soll. So muss zur Kühlung des ersten Kühlkreislaufs auf die Kältemaschine nur dann zurückgegriffen werden, wenn beispielsweise aufgrund hoher Außentemperatur eine Kühlung über einen extern angeordneten Wärmetauscher nicht mehr möglich ist. Der energieintensive Einsatz der Kältemaschine wird so auf ein Minimum reduziert, gleichzeitig kann durch das System auch bei sehr hohen Außentemperaturen eine sichere Kühlung bereitgestellt werden.

Bei einer Ausführungsform der Erfindung kann das Kühlfluid durch in der Nähe angeordnete Wärmetauscher geleitet werden, welche mit den Leiterplatten verbunden sind, und somit die Leiterplatten und/oder die mit der Leiterplatte thermisch verbundenen Bauteile kühlen. Ebenso können auch die Leiterplatten selber von Kühlfluid durchströmt werden.

Eine Ausführungsform der Erfindung umfasst zumindest drei Kühlkreisläufe, von denen ein Kühlkreislauf mittels Luft betrieben wird und die beiden weiteren Kühlkreisläufe mittels einer Flüssigkeit oder Wärmeleitung betrieben werden, wobei von den beiden weiteren, also den flüssigkeitsbasierten Kühlkreisläufen, zumindest ein Kühlkreislauf sowohl mit einem externen Wärmetauscher als auch mit einem Kaltteil der Kältemaschine verbindbar ist. Das so definierte System arbeitet quasi dreistufig. Es ist insbesondere vorgesehen, drei Kühlkreisläufe mit unterschiedlich hoher Vorlauftemperatur bereitzustellen.

Beispielsweise können die Prozessoren der Rechenanlage mit einem ersten Kühlkreislauf mit der höchsten Vorlauftemperatur gekühlt werden. Dieser Kühlkreislauf benötigt zumeist nicht die Unterstützung einer Kältemaschine, sondern es ist zumindest in den gemäßigten Klimazonen möglich, die Wärme über einen externen Wärmetauscher nach außen abzuführen. Alternativ ist es auch möglich, das hohe Temperaturniveau für andere Zwecke zu nutzen, beispielweise für die Gebäudeheizung, Warmwassererzeugung oder Energieerzeugung. Es versteht sich, dass es dennoch sinnvoll sein kann, das System derart auszugestalten, dass auch die Flüssigkeit dieses Kühlkreislaufs dem Kaltteil der Kältemaschine zugeführt werden kann, um auch bei extrem hohen Außentemperaturen eine sichere Kühlung bereitzustellen.

Ein weiterer flüssigkeitsbasierter Kühlkreislauf wird mit einer Vorlauftemperatur betrieben, welche zwischen der Vorlauftemperatur des erstgenannten Kühlkreislaufs und der Vorlauftemperatur eines weiteren, insbesondere luftbasierten, Kühlkreislaufs liegt. An diesen Kühlkreislauf kann eine weitere Gruppe Wärme erzeugender Bauelemente angeschlossen sein, welche mit einer geringeren Vorlauftemperatur als die Komponenten des ersten Kühlkreislaufs gekühlt werden. Dabei kann es sich beispielsweise um Festplatten und Speicherbauteile handeln.

Bei diesem zweiten Kühlkreislauf wird, wann immer es möglich ist, auf einen externen Wärmetauscher zurückgegriffen, so dass auf die Verwendung der Kältemaschine verzichtet werden kann. So ist es je nach Klimazone möglich, auch diesen weiteren Kühlkreislauf zumindest in den Wintermonaten ohne die Verwendung einer Kältemaschine zu betreiben. Bei höheren Außentemperaturen wird dagegen durch eine variable Verteilung der Kühlflüssigkeit auf die Kältemaschine zurückgegriffen.

Ein weiterer Kühlkreislauf ist in der Regel luftbasiert und arbeitet mit geringerer Vorlauftemperatur als die beiden vorher genannten Kühlkreisläufe. Über diesen Kühlkreislauf wird beispielsweise die Luft in den Racks oder auch die Luft im Raum, in welchem die Rechenanlage aufgestellt ist, gekühlt. Da hierzu Temperaturen in der Regel von 20°C oder weniger erforderlich sind, ist in der Regel die Verwendung einer Kältemaschine erforderlich. Aufgrund der Wärmeabfuhr über die beiden anderen Kühlkreisläufe ist es aber möglich, die Verwendung der Kältemaschine erheblich zu reduzieren. Es versteht sich, dass je nach Größe und Auslegung der Anlage auch noch weitere Kühlkreisläufe mit Zwischentemperaturen vorhanden sein können, um das System derart zu optimieren, dass möglichst viel Wärme ohne die Verwendung von Kältemaschinen abgeführt werden kann.

Weiter kann das System, wie es bei einer Weiterbildung der Erfindung vorgesehen ist, Mittel zur variablen Verteilung des Kühlfluids innerhalb der Rechenanlage aufweisen.

Es ist insbesondere vorgesehen, die Kühlleistung je nach Bedarf auslastungsabhängig innerhalb der Rechenanlage zu verteilen. Zur Optimierung der Kühlmittelverteilung kann, wie es bei einer Ausführungsform der Erfindung vorgesehen ist, dass System zur Kühlung der Rechenanlage mit der Rechenanlage selbst vernetzt sein. So ist beispielsweise denkbar, dass zumindest einzelne Server der Rechenanlage über eine Schnittstelle die jeweilige Auslastung und/oder die jeweilige Temperatur an eine Regelungselektronik des Kühlsystems weitergeben, so dass das Kühlsystem auslastungsspezifisch geregelt wird, insbesondere in Bezug auf die lokale Verteilung unterschiedlicher Rechenleistungen oder Abwärmeerzeugung innerhalb von Servern, Racks, Komponenten des Rechenzentrums, sowie innerhalb des Rechenzentrums selber.

Ein Vorteil einer derartigen Regelungstechnik liegt unter anderem darin begründet, dass bereits in einem sehr frühen Stadium, nämlich unmittelbar mit Anstieg der Auslastung der Rechenanlage, zusätzliche Kühlleistung angefordert wird. Das kann zum Beispiel bei Kühlanlagen mit Kältespeicher die notwendige Kapazität von thermischen Speichern zur Kältespeicherung reduzieren, indem die Kältemaschine bereits zugeschaltet wird, sobald ein zusätzlicher Bedarf an Kälteenergie auf Grund der Auslastung der Rechenanlage abzusehen ist (und nicht erst wenn die Temperatur in der Rechenanlage bereits angestiegen ist), und somit die durch einen Kältespeicher zu überbrückende Zeit zwischen Bedarf der Kälteenergie und Bereitstellung durch die Kältemaschine erforderliche Kälteenergie reduziert wird (die Kältemaschine benötigt in der Regel einige Sekunden oder Minuten nach der Zuschaltung, um die Kälteenergie bereitzustellen). Kleinere thermische Buffer ermöglichen kompaktere Bauformen, was insbesondere bei in die Rechenanlage, z.B. Racks integrierten, oder bei mit den Racks verbundenen Kühlmodulen von Vorteil sein kann.

Weiter ist denkbar, bei steigender Rechenleistung die Menge des zugeführten Kühlmittels zu erhöhen und/oder dessen Temperatur herab zu setzen. Insbesondere ist auch denkbar, zumindest einen Kühlkreislauf bei ansteigender Rechenleistung mit niedrigerer Temperatur zu betreiben.

Gegenüber einfacheren Regelungssystemen, die beispielsweise auf Basis der Rücklauftemperatur gesteuert werden, kann weiterhin auf diese Weise das Kühlsystem bei geringerer Besonders von Vorteil ist dies in Verbindung mit der ebenfalls beschriebenen modularen Ausgestaltung oder der Ausgestaltung, bei der die Kältemaschine im Server integriert oder direkt mit dem Server verbunden ist.

Bei einer Ausführungsform der Erfindung umfasst das System zumindest redundant ausgebildete Pumpen zur Verteilung des Kühlfluids und/oder eine redundant ausgebildete Kältemaschine. Zumindest bei größeren Server-Farmen muss auch beim Ausfall einzelner Komponenten des Kühlsytems eine dauerhafte Weiterversorgung mit dem Kühlfluid über einen längeren Zeitraum sichergestellt werden, wofür Pufferspeicher in der Regel nicht ausreichend sind.

Zur Notkühlung kann beispielsweise auch ein zusätzlicher herkömmlicher Kältekompressor oder eine Einspeisung von kaltem Leitungswasser in das System vorgesehen sein.

Weiterhin können auch die Kühlkreisläufe selber redundant ausgeführt sein, so dass beispielsweise bei Verlust von Kühlflüssigkeit in einem Kühlkreislauf die Wärme durch einen dazu redundanten Kühlkreislauf abgeführt werden kann.

Bei einer Weiterbildung der Erfindung kann das System auch in eine bestehende Gebäudeklimatisierung und/oder Warmwasserversorgung und/oder Elektroenergieversorgung integriert sein. So ist beispielsweise denkbar, die an einer Kältemaschine anfallende Prozesswärme zumindest teilweise zur Beheizung des Gebäudes und/oder zur Warmwasserversorgung zu verwenden. Es ist auch denkbar, die Prozesswärme zur Stromerzeugung zu verwenden, beispielsweise durch Peltierelemente. Unter Prozesswärme Auslastung der Rechenanlage mit einer erheblich reduzierten Leistung betrieben werden, ohne zu riskieren, dass im Falle plötzlich steigender Auslastung aufgrund der geringen zugeführten Kühlleistung es zu Überhitzungen einzelner Komponenten kommt.

Auf den einzelnen Rechnern kann zur Steuerung der Rechenanlage ein im Hintergrund laufendes Programm zur Temperaturüberwachung installiert sein, welches bei steigendem Kühlbedarf dies an die Regelung des Kühlsystems weitergibt. Als Schnittstelle im Sinne der Erfindung kann beispielsweise auch ein ohnehin vorhandener LAN-Anschluss genutzt werden.

Denkbar ist auch eine Fernüberwachung und/oder Steuerung des Kühlsystems über ein Netzwerk, insbesondere Internetbasiert.

Bei einer Ausführungsform der Erfindung umfassen sowohl der erste Kühlkreislauf als auch der Warmteil der Kältemaschine jeweils einen Wärmetauscher, welche über einen weiteren Wärmetauscher thermisch verbunden sind, so dass die Abwärme beider Kühlkreisläufe gemeinsam abführbar ist. Dieser Ausführungsform der Erfindung liegt die Erkenntnis zugrunde, dass der Warmteil einer Kältemaschine, insbesondere einer Kompressionskältemaschine, über den in der Regel die dem System entzogene Wärme nach außen abgeführt wird, und eine Prozessorkühlung mit ähnlichen Vorlauftemperaturen betrieben werden können. Koppelt man nun die beiden Kühlkreisläufe über Wärmetauscher, ist es möglich, die entstehende Wärme über einen einzigen Wärmetauscher nach außen abzuführen. Dies hat den Vorteil, dass lediglich ein externer Anschluss vorhanden sein muss. wird jegliche Energieentnahme aus dem Kühlsystem verstanden, was auch unter dem Begriff Rückkühlung bekannt ist.

Es ist aber auch, wie es bei einer Weiterbildung der Erfindung vorgesehen ist, denkbar, eine Kältemaschine zu verwenden, welche als Antriebsenergie mit Wärme betrieben wird. Dies ist insbesondere bei Sorptionskältemaschinen der Fall. Bei einer derartigen Ausführungsform der Erfindung ist es denkbar, den ersten Kühlkreislauf, welcher mit höherer Vorlauftemperatur arbeitet, mit dem Warmteil der Kältemaschine zu verbinden und so Antriebsenergie zur Verfügung zu stellen. Der zweite Kühlkreislauf kann sodann mit dem Kaltteil der Kältemaschine verbunden werden, so dass diese beispielsweise die Luft in den Servern kühlt. Besonders von Vorteil ist dabei, wenn das aus dem Warmteil der Kältemaschine ausströmende Fluid über einen externen Wärmetauscher geführt wird. Dieses hat nämlich in der Regel immer noch eine hinreichend hohe Temperatur, dass Wärme ohne die Verwendung von Kältemaschinen extern nach außen abgeführt werden kann (abhängig von den jeweiligen beispielsweise klimatisch bedingten Außentemperaturen).

Bei einer bevorzugten Ausführungsform der Erfindung ist das System modular ausgebildet und umfasst zumindest ein Kühlmodul, in welchem zumindest die Kältemaschine und eine elektronische Steuerung angeordnet sind. Insbesondere ist vorgesehen, ein Modul bereitzustellen, welches aus einem Gehäuse mit Anschlüssen besteht und an welchem neben einer Stromversorgung, gegebenenfalls der Anbindung der Rechenanlage über eine Schnittstelle, Zu- und Rücklaufleitungen der Kühlung der Rechenanlage anschließbar sind. Weiter umfasst das Modul vorzugsweise Anschlüsse für einen externen Wärmetauscher, über den Prozesswärme der Kältemaschine abgeführt wird.

Auch die Steuerung des Systems zur Kühlung einer Rechenanlage ist in dem Modul integriert.

Die Module sind vorzugsweise in den Systemabmessungen von Komponenten des Rechenzentrums ausgebildet, z.B. als 19"-System für Komponenten in Racks.

Anschlüsse zum elektrischen Anschluss, zur Kommunikation und/oder Kühlleitungen sind vorzugsweise derart ausgebildet, dass sich diese bei Einsetzen des Moduls automatisch verbinden. So wird eine schnellere Installation beim Service und Austausch verwirklicht.

Weiter verfügt das Modul bei einer bevorzugten Ausführungsform der Erfindung zumindest über eine autarke Notstromversorgung, über die zumindest der Antrieb der Pumpen, mit denen das Kühlfluid der Rechenanlage zugeführt wird, auch im Falle eines Stromausfalls gewährleistet wird. Es ist denkbar, dass zumindest auch eine Regelungselektronik des Kühlsystems mit der Notstromversorgung verbunden ist. Zur einfacheren Regelung ist auch denkbar, dass die Pumpen derart angesteuert sind, dass sie bei ausgeschalteter Regelungselektronik weiter laufen.

Alternativ kann die Notstromversorgung des Kühlsystems auch über eine Notstromversorgung der Rechenanlage sichergestellt werden, insbesondere über eine unterbrechungsfreie Stromversorgung.

Rechenanlagen weisen in der Regel eine unterbrechungsfreie Stromversorgung auf. Derartige unterbrechungsfreie Stromversorgungen von Rechenanlagen werden in der Regel ebenfalls gekühlt. Es ist daher vorgesehen, das System zur Kühlung auch für die unterbrechungsfreie Stromversorgung zu verwenden. Eine unterbrechungsfreie Stromversorgung umfasst in der Regel zumindest Akkumulatoren, mit denen sich kurzzeitige Unterbrechungen der Netzspannung überbrücken lassen. Die unterbrechungsfreie Stromversorgung springt in der Regel innerhalb weniger Millisekunden an, so dass auch nur kurzeitig auftretende Störungen der Spannung kompensiert werden.

Eine Rechenanlage verfügt in der Regel auch über Telekommunikationseinrichtungen wie Anschlussmodule an ein Telekommunikationsnetz. Es versteht sich, dass das erfindungsgemäße Kühlsystem, soweit erforderlich, auch die Kühlung dieser Telekommunikationsmodule sicherstellt.

Bei einer weiteren Ausführungsform der Erfindung ist eine Flüssigkeit des zweiten Kühlkreislaufs nach Durchlaufen eines Kaltteils der Kältemaschine über einen Wärmetauscher zur Kühlung der in der Rechenanlage vorhandenen Luft führbar. Der zweite Kühlkreislauf ist also, wie bereits vorstehend beschrieben, luftbasiert, wobei die Luft über einen Wärmetauscher abgekühlt wird, welcher beispielsweise in einem Rack der Rechenanlage integriert ist.

Bei dieser Ausführungsform der Erfindung wird die Flüssigkeit nach Durchlaufen des Wärmetauschers dem ersten Kühlkreislauf zugeführt. Es handelt sich hierbei also um eine Ausführungsform, bei der die beiden Kühlkreisläufe hintereinander geschaltet sind, so dass die Kühlflüssigkeit zunächst den zweiten Kühlkreislauf, welcher mit niedriger Vorlauftemperatur betrieben wird, mit Kälte versorgt und sodann mit höherer Temperatur dem ersten Kühlkreislauf, insbesondere der Prozessorkühlung zugeführt wird.

Bei einer Weiterbildung der Erfindung ist die Kältemaschine in einem Rack oder in einen Server integriert. So lassen sich insbesondere Kältemaschinen auch dezentral im System unterbringen. Auch kann sich so beispielsweise ein Server selbst kühlen. Dabei kann jeder Kühlkreislauf auf das jeweilige Gerät optimiert sein. Unter einem Anschluss für einen Kühlkreislauf im Sinne der Erfindung werden alle möglichen Arten von Schnittstellen, über die Wärmeenergie übertragen werden kann, verstanden.

Bei einer Ausführungsform der Erfindung sind integrierte oder unmittelbar an einen Server angrenzende Kältemaschinen vorgesehen, die als Modul ausgebildet sind.

Vorzugsweise umfasst das jeweilige Modul Wärmetauscher, Controller, Pumpen, Schnittstellen und die Kältemaschine selbst. Aber auch die Bereitstellung nur der Kältemaschine selbst als Modul ist denkbar.

Auch kann die Kältemaschine (vorzugsweise ausgeführt als Modul), wie es bei einer weiteren Ausführungsform der Erfindung vorgesehen ist, unmittelbar an den Server oder das Rack angrenzen. Beispielsweise kann die Kältemaschine oberhalb oder unterhalb eines Servers oder Racks vorhanden sein. So ist keine zusätzliche Grundfläche nötig. Weiterhin kann das Kältemodul seitlich angeordnet sein, auch kann ein Kältemodul mehrere Komponenten, z.B. Racks mit Kälteenergie versorgen.

Es ist bekannt, dass Wärmetauscher und Ventilatoren zur Erzeugung eines internen Luftkreislaufes zur Kühlung beispielsweise eines Racks beispielsweise einer Rackkühlung sowohl innerhalb als auch angrenzend an beispielsweise einem Rack angeordnet sein kann. So ist als eine weitere Ausführungsform des Kühlmoduls eine Anordnung des Kühlmoduls innerhalb einer solchen Einheit zur internen Kühlung beispielsweise eines Racks möglich.

Bei einer Ausführungsform der Erfindung ist die Kältemaschine in einem Server, insbesondere in einem Blade-Server, integriert.

So ist gemäß einer Ausführungsform vorgesehen, dass die Kältemaschine als ein im Server einsetzbares, insbesondere einsteckbares Modul ausgebildet ist. Diese Ausführungsform der Erfindung kann beispielsweise für herkömmliche Blade-Server verwendet werden.

Die Integration in dem Server oder die Rechenanlage, oder die unmittelbar benachbarte Anordnung ermöglicht kurze Leitungslängen und Übertragungswege für das Kühlmittel (Flüssigkeit, Wärmeleitung, Luft), wodurch thermische Verluste des Kältetransportes verringert werden, weiterhin die für den Kältetransport benötigte Energie zur Übertragung verringert werden kann (z.B. die Pumpenleistung), und somit die Effizienz gesteigert wird. Weiterhin ermöglicht Integration oder benachbarte Anordnung der Kühlmodule einen modularen Aufbau des Rechenzentrums im Bezug auf das Kühlsystem; die Komponenten (z.B. Racks) umfassen jeweils ein eigenes, auf die Komponente zugeschnittenes Kühlsystem. Somit ist das Rechenzentrum erweiterbar, ohne eine zentrale Kühlanlage erweitern oder in ihrer Kühlkapazität erweitern zu müssen (mit Ausnahme der Abführung der Prozesswärme). Weiterhin ist ein Rechenzentrum denkbar, welches keine zentrale Kühlanlage benötigt (mit Ausnahme der Abführung der Prozesswärme). Ein weiterer Vorteil integrierter oder angrenzender Kühlmodule ist, je nach Ausführungsform, eine Reduzierung der externen Anschlüsse für die Kühlkreisläufe, wenn innerhalb der Kühlmodule bereits mehrere Kühlkreisläufe zusammengeführt werden. So ist als externer Anschluss beispielswiese Abi 27.1. Schreibfehler: "beispielsweise" lediglich ein Fluidanschluss zur Abführung von Prozesswärme nötig. Ansonsten können alle Komponenten in dem Server bzw. Rack integriert sein.

Ein System zur Kühlung einer Rechenanlage kann so ausgeführt sein, dass nicht angrenzende und nicht integrierte Kühlmodule oder Kältemaschinen, und angrenzende oder integrierte Kältemaschinen oder Kühlmodule in einer hinsichtlich Investitionskosten und Betriebskosten optimalen Kombination angewendet werden.

Bei einer Weiterbildung der Erfindung umfasst das System zur Kühlung einer Rechenanlage ein beispielsweise auch als Modul ausgeführtes System zur Erkennung eines Kühlmittelverlustes und zur und Einleitung einer Notabschaltung im Falle eines Kühlmittelverlustes.

Insbesondere sind die Mittel zur Notabschaltung als Unterbrecher für die Spannungsversorgung ausgebildet.

Es ist beispielsweise denkbar, zentral über den Druck in einem flüssigkeitsbasierten Kühlsystem, welches zur Druckerkennung vorzugsweise mit einem Überdruck betrieben wird, zu erkennen, ob ein Flüssigkeitsleck vorliegt.

Im Falle eines Druckabfalls kann sodann beispielsweise die gesamte Rechenanlage oder Abschnitte der Rechenanlage und/oder die Pumpen zum Umwälzen des Kühlmittels abgeschaltet werden, so dass die Komponenten spannungsfrei sind. So ist sichergestellt, dass allenfalls Komponenten beschädigt werden, welche unmittelbar mit dem Kühlwasser in Kontakt kommen, und weitere Beschädigung der Komponenten infolge elektrischer Stromleitung des Kühlwassers durch Abschaltung der Stromversorgung der Komponenten vermieden werden.

Weiter ist denkbar, dass die Notabschaltung eine Pumpe umfasst, über die im Falle der Erkennung eines Flüssigkeitsverlustes ein Unterdruck im Kühlmittelsystem erzeugt wird. Beispielsweise kann die Pumpe die Flüssigkeit in ein dafür vorgesehenes Reservoir oder auch in die Kanalisation abpumpen. Aufgrund des entstehenden Unterdruckes tritt kein oder nur wenig weiteres Wasser aus, so dass der Schaden in der Anlage lokal begrenzt bleibt.

Bei einer weiteren Ausführungsform der Erfindung sind Mittel zur Notabschaltung in einem Rack der Rechenanlage integriert.

Beispielsweise kann jedes Rack Mittel zur Erkennung eines Kühlflüssigkeitsverlustes aufweisen, insbesondere einen Feuchtigkeitssensor. Im Falle eines Flüssigkeitsaustritts wird die Spannungsversorgung des Racks getrennt. Es ist dabei gleichzeitig auch denkbar, das Rack mit automatisch schließenden Ventilen auszustatten, so dass dieses von dem Kühlmittelkreislauf abgetrennt wird. Der Vorteil dieser Ausführungsform der Erfindung ist, dass so nicht die gesamte Rechenanlage ausfällt und gleichzeitig verhindert wird, dass größere Mengen von Flüssigkeit aus einem Rack austreten können.

Weiterhin kann das Modul zur Erkennung eines Kühlmittelverlustes Bestandteil eines Kühlmodules sein.

Die Erfindung ermöglicht in einer Ausführungsform ein System zur Kühlung einer Rechenanlage, welches mehrere Kühlkreisläufe umfasst, wobei ein Kühlkreislauf ohne Verwendung der Kältemaschine kühlbar ist und ein weiterer Kühlkreislauf unter Verwendung der Kältemaschine kühlbar ist. Es ist insbesondere vorgesehen, die Abwärme eines ersten Kühlkreislaufs mit höherer Vorlauftemperatur und höherer Rücklauftemperatur ohne die Verwendung einer Kühlmaschine abzuführen, indem hierfür die Außenluft zur Rückkühlung verwendet wird oder indem die Wärme als Nutzwärme beispielsweise für Heizung und Warmwasserversorgung verwendet wird.

Alternativ oder in Kombination sind zumindest zwei Kühlkreisläufe thermisch gekoppelt und so zu einem Kühlkreislauf zusammengefasst.

Es ist insbesondere vorgesehen, dass zumindest zwei Kühlkreisläufe mit niedrigerer und höherer Vorlauftemperatur hintereinandergeschaltet sind. So kann beispielsweise der Rücklauf einer Rackkühlung zur Kühlung von Leistungsbauteilen und Prozessoren genutzt werden.

Bei einer Ausführungsform der Erfindung ist über den zusammengeführten Kühlkreislauf Prozesswärme abführbar. Insbesondere wird der Rücklauf des letzten Kühlkreislaufes, in dem die höchste Temperatur anliegt, einer Rückkühlung zugeführt.

Bei einer Weiterbildung der Erfindung umfasst das System zur Kühlung einer Rechenlage mehrere Kühlkreisläufe, wobei zumindest in einem Kühlkreislauf ein Bypass vorgesehen ist, über den durch teilweise Rückführung des Kühlmittels der Volumenstrom in dem am Kühlkreislauf angeschlossenen zu kühlenden Modul erhöht werden kann, ohne den gesamten Volumenstrom des Kühlmittels im Kühlkreislauf zu erhöhen. Es kann also vorgesehen sein, den gesamten Volumenstrom im Wesentlichen konstant zu halten, wobei ein Teil des Volumenstroms über einen Bypass an zu kühlenden Bauteilen vorbeigeführt wird. Wird nun zusätzliche Kühlung benötigt, kann die Durchflussmenge im Bypass reduziert werden, wodurch die Durchflussmenge entlang der zu kühlenden Bauteile steigt.

Es ist aber umgekehrt auch denkbar, den Volumenstrom im am Kühlkreislauf angeschlossenen Modul zu verringern, ohne den gesamten Volumenstrom im Kühlkreislauf zu verringern.

Bei einer Ausführungsform der Erfindung wird als Kühlmittel eine Flüssigkeit mit einer elektrischen Leitfähigkeit mit weniger als 10×10⁻⁶ S/m verwendet. Insbesondere kann reines Wasser oder ein Wasser-Glykol-Gemisch verwendet werden. Elektrische Beschädigungen der Komponenten der Rechneranlage und die Gefahr eines Stromschlages für Bedienpersonal werden so reduziert.

Bei einer Ausführungsform der Erfindung sind auch Komponenten der Kältemaschine, insbesondere ein Kompressor, über zumindest einen der Kühlkreisläufe kühlbar. Die Kältemaschine wird somit in die Kühlung des Systems auf einfache Weise eingebunden und wird insbesondere über eine Flüssigkeit gekühlt.

Insbesondere kann durch Anschluss des Kompressors beziehungsweise des Motors des Kompressors an einen der flüssigkeitsbasierten Kühlkreisläufe beispielsweise die Abwärme des Kompressors beziehungsweise Motors des Kompressors (Motorwärme) als thermische Energie weiterverwendet werden (beispielsweise zur Gebäudeheizung oder Erzeugung von Elektroenergie). Weiterhin kann ebenfalls dadurch verhindert werden, dass die Kühlenergie zum Kühlen des Kompressors der Kältemaschine durch die Kältemaschine selbst (oder eine andere Kältemaschine) erzeugt werden muss, indem die Motorwärme in einem anderen Kühlkreislauf abgeführt wird, der beispielsweise auf Grund seiner hohen Temperatur direkt ohne weitere Kühlmaschine in der Rückkühlung gekühlt werden kann. Damit verringert sich der Energieaufwand zur Kühlung des Rechenzentrums.

Bei einer weiteren bevorzugten Ausführungsform der Erfindung wird eine Kältemaschine mit einem Kompressor verwendet, welcher eine Sanftanlaufschaltung umfasst.

Durch eine Sanftanlaufschaltung wird der Einschaltstrom reduziert und somit das Drehmoment des Motors in der Anlaufphase herabgesetzt. Neben einem sanfteren Anlaufen kann so die Lebensdauer des Motors signifikant erhöht werden.

Die Erfindung ermöglicht eine im Wesentlichen thermisch neutrale Rechenanlage, bei welcher lediglich eine Heizleistung von weniger als 20 %, vorzugsweise weniger als 10 % der Leistungsaufnahme der Rechenanlage als thermische Energie in einen Raum, in welchem die Rechenanlage angeordnet ist, abgegeben wird. Somit kann in vielen Fällen auf eine Kühlung des Raumes durch eine energieaufwändige Kältemaschine verzichtet werden.

Die Rechenanlage kann so ggf. auch in Bürobereichen etc. aufgestellt werden.

Zur Reduzierung von Wärmeeintrag in die Umgebung kann ein Gehäuse der Rechenanlage isoliert sein, insbesondere Gehäusewände mit einem Wärmedurchgangskoeffizienten k < 3 W/m²K, vorzugsweise k < 1 W/m²K aufweisen.

Hierzu können die Gehäusewände aus einem wärmeisolierenden Material, wie beispielsweise Hartschaum, bestehen. Auch ist denkbar, isolierendes Material auf die Innen- und/oder Außenseite der Gehäusewände aufzubringen.

Weiter können die Gehäusewände der Rechenanlage über Fluidleitungen, die an einem Kühlkreislauf angeschlossen sind, in etwa auf die Umgebungstemperatur kühlbar sein. Hierzu können die Wände doppelwandig ausgebildet sein oder Kühlschlangen umfassen. Durch eine Kühlung der Wände kann auch bei einer Temperatur im Gehäuse oberhalb der Raumtemperatur ein unerwünschter Wärmeeintrag in die Umgebung verhindert werden.

Die Erfindung betrifft des Weiteren eine Rechenanlage, insbesondere eingebettet in ein vorstehend beschriebenes System zur Kühlung einer Rechenanlage. Insofern vorstehend Details der Rechenanlage und deren Kühlsystem beschrieben sind, kann auf die entsprechenden die Rechenanlage betreffenden Merkmale verwiesen werden, ohne dass die Rechenanlage zwingend Teil des vorstehend beschriebenen Systems ist.

Die Rechenanlage umfasst ein Gehäuse, in welchem die Komponenten der Rechenanlage, insbesondere Prozessoren, Speicher, Festplatten etc. angeordnet sind.

Gemäß der Erfindung umfasst die Rechenanlage zumindest einen ersten und einen zweiten Kühlkreislauf, wobei über den ersten Kühlkreislauf über eine Flüssigkeit und/oder über Wärmeleitung Prozessoren und Leistungsbauteile der Rechenanlage kühlbar sind und wobei der zweite Kühlkreislauf einen in dem Gehäuse angeordneten Wärmetauscher umfasst.

Über den Wärmetauscher, welcher insbesondere über eine Flüssigkeit kühlbar ist, wird das Innere des Gehäuses über einen Kühlkreislauf gekühlt und so thermische Energie, welche nicht über den ersten Kühlkreislauf abgeführt wird, abgeführt. Der Wärmetauscher kann beispielsweise eine im Rack angeordnete Kühlschlange umfassen oder Kanäle im Gehäuse.

Vorzugsweise umfasst die Rechenanlage Fluidanschlüsse sowohl für den ersten als auch für den zweiten Kühlkreislauf.

Während über den ersten Kühlkreislauf der überwiegende Teil der thermischen Energie aufgrund der hohen Temperatur über freie Kühlung abgeführt werden kann, ist es, abweichend von vorstehend beschriebenem System zur Kühlung einer Rechenanlage, auch denkbar, für die über den zweiten Kühlkreislauf abgeführte verbleibende thermische Energie auf die Verwendung einer Kältemaschine zu verzichten und auch diesen Kühlkreislauf über freie Kühlung zu betreiben.

Die Rechenanlage kann so thermisch neutral ausgebildet sein.

Das Gehäuse ist vorzugsweise als Rack ausgebildet.

Die Erfindung betrifft des Weiteren ein Kühlmodul, insbesondere für ein vorstehend beschriebenes System zur Kühlung einer Rechenanlage.

Das Kühlmodul umfasst einen Anschluss für einen ersten Kühlkreislauf, insbesondere einen Kühlkreislauf mit welchem Prozessoren und Leistungsbauteile einer Rechenanlage mit einer Flüssigkeit gekühlt werden können. Weiter umfasst das Kühlmodul einen weiteren Anschluss für einen weiteren Kühlkreislauf. Über diesen weiteren Kühlkreislauf können beispielsweise Gehäuse oder Server einer Rechenanlage mit einer niedrigeren Temperatur gekühlt werden. Weiter umfasst das Kühlmodul einen Anschluss zum Abführen von Prozesswärme. Über diesen Anschluss erfolgt die Rückkühlung derart, dass dem Kühlsystem Wärmeenergie entnommen wird.

Bei einer bevorzugten Ausführungsform der Erfindung umfasst das Kühlmodul eine Kältemaschine. Die Kältemaschine ist insbesondere dafür vorgesehen, eine hinreichend niedrige Temperatur für den zweiten Kühlkreislauf bereit zu stellen, welcher mit geringerer Vorlauftemperatur betrieben wird. Das Kühlmodul ist bei einer Weiterbildung der Erfindung als Einsteckmodul für einen Server, insbesondere einen Blade Server, ausgebildet.

Hierzu umfasst das Kühlmodul mechanische Mittel, um es in einem Steckplatz einzusetzen. Das Kühlmodul ist in einer Normgröße ausgebildet, dass es einen oder mehrere Einsteckplätze eines Servers belegt.

Die Erfindung betrifft weiterhin ein Gehäuse einer Rechenanlage, welches insbesondere als Rack ausgebildet ist. Das Gehäuse umfasst einen im Gehäuse angeordneten Wärmetauscher und einen Fluidanschluss der mit dem Wärmetauscher verbunden ist. Auch die Gehäusewände können als Wärmetauscher ausgebildet sein.

Über den Wärmetauscher kann das Innere des Gehäuses gekühlt werden.

Weiter umfasst das Gehäuse einen weiteren Fluidanschluss an welchem Module, insbesondere Einschubmodule oder Leistungsbauteile, anschließbar sind.

Weiter betrifft die Erfindung ein Rechenmodul, welches als Einschubmodul für ein Rack ausgebildet ist. Ein Rechenmodul kann zum Beispiel Prozessoren aber auch Festplatten, Telekommunikationselektronik etc. umfassen.

Gemäß der Erfindung umfasst das Rack einen Fluidanschluss, über welchen Prozessoren und Leistungsbauteile des Rechenmoduls mit einem Kühlfluid versorgbar sind.

Das Rechenmodul kann einen weiteren Fluidanschluss zum Führen von Kühlfluid aufweisen, über den insbesondere das Gehäuse des Rechenmoduls, beispielsweise über einen integrierten Wärmetauscher, gekühlt wird. Es ist aber auch denkbar, die Gehäusekühlung rein luftbasiert auszuführen derart, dass das Gehäuse, in welchem sich das Rechenmodul befindet, über einen im Gehäuse angeordneten Wärmetauscher heruntergekühlt wird.

Die Erfindung betrifft des Weiteren ein Modul zur Erkennung eines Lecks, insbesondere für ein vorstehend beschriebenes System zur Kühlung einer Rechenanlage. Das Modul umfasst Mittel zur Erkennung eines Lecks im Kühlsystem, einen Controller sowie Mittel um eine Rechenanlage zumindest teilweise abzuschalten.

Vorzugsweise ist das Modul zur Erkennung eines Lecks derart ausgebildet, dass dieses anhand von gemessenen Parametern wie Druck im Fluidsystem, Nässesensoren etc., den Ort oder die Größe des Lecks erkennt und sodann je nach Ort oder Schwere die Rechenanlage gezielt herunterfährt oder eine Notabschaltung durch Unterbrechung der Stromversorgung durchführt.

Das Modul zur Erkennung eines Lecks kann in einer anderen Komponente integriert sein, wie beispielsweise dem vorstehend beschriebenen Kühlmodul. Ebenso ist es auch denkbar, das Modul selbst als Einsteckmodul für einen Server auszubilden.

Die Erfindung betrifft des Weiteren ein Verfahren zur Kühlung einer Rechenanlage, insbesondere mittels eines vorstehend beschriebenen Systems zur Kühlung einer Rechenanlage.

Die Rechenanlage umfasst zumindest einen ersten und einen zweiten Kühlkreislauf, wobei der erste Kühlkreislauf mit höherer Temperatur als der zweite Kühlkreislauf und mittels einer Flüssigkeit und/oder mittels Wärmeleitung betrieben wird. Insbesondere unterscheiden sich die Vorlauftemperaturen der beiden Kühlkreisläufe um zumindest 20°C, vorzugsweise zumindest 30°C.

Weiter wird zumindest der zweite Kühlkreislauf über einen Kaltteil einer Kältemaschine betrieben.

Durch die Erfindung kann die über die Kältemaschine erzeugte Kühlleistung auf ein Minimum reduziert werden, da der erste Kühlkreislauf, welcher beispielsweise als Prozessorkühlung, wie vorstehend definiert, ausgeführt ist, mit einer derart hohen Vorlauftemperatur betrieben wird, dass zumindest zu einem überwiegenden Teil der Zeit die Wärme ohne die Verwendung einer Kältemaschine abgeführt werden kann.

Bei einer Weiterbildung der Erfindung wird der Rücklauf des ersten Kühlkreislaufs zeitweise sowohl mit einem Wärmetauscher als auch mit dem Kaltteil der Kältemaschine verbunden, insbesondere mittels eines Wegeventils.

Abwärme des ersten Kühlkreislaufs wird somit nur dann der Kältemaschine zugeführt, wenn beispielsweise aufgrund hoher Außentemperaturen die externe Abfuhr, beispielsweise über einen Wärmetauscher, nicht möglich ist.

Über den ersten Kühlkreislauf werden vorzugsweise Prozessoren und/oder Leistungsbauteile der Rechenanlage gekühlt, wohingegen über den zweiten Kühlkreislauf vorzugsweise die Racks der Rechenanlage und/oder der Raum, in welchem sich diese befinden, gekühlt werden.

Unter einem Wärmetauscher wird auch verstanden, dass die Wärme des Warmteils der Kältemaschine und/oder die Wärme des ersten Kühlkreislaufs für Nutzwärme zur Verfügung gestellt werden, insbesondere zur Gebäudeheizung und/oder Wasserbereitung.

### Beschreibung der Zeichnungen

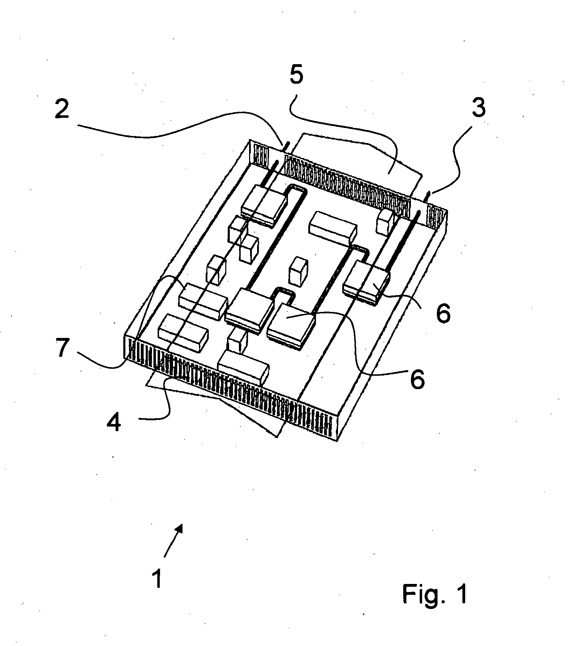

Fig. 1 zeigt ein erstes Ausführungsbeispiel eines Systems zur Kühlung einer Rechenanlage 1 in einer schematischen Ansicht.

Gezeigt ist ein Server mit zwei Kühlkreisläufen.

Der erste Kühlkreislauf ist ein flüssigkeitsbasierter Kühlkreislauf und umfasst einen Vorlauf 2 und einen Rücklauf 3, über den flüssigkeitsgekühlte Komponenten, wie beispielsweise Prozessoren und weitere Leistungsbauteile, gekühlt werden können.

Weiter umfasst das System zur Kühlung einer Rechenanlage 1 einen zweiten Kühlkreislauf in Form einer Luftkühlung, umfassend einen Fluideinlass 4 und einen Auslass 5. Dieser zweite Kühlkreislauf ist mit einer Kältemaschine (nicht dargestellt) gekoppelt.

Über den zweiten Kühlkreislauf werden Komponenten 7, welche nicht an den Flüssigkeitskühlkreislauf angeschlossen sind, gekühlt.

Der erste Kühlkreislauf ist über den Vorlauf 2 und den Rücklauf 3 mit einem Wärmetauscher gekoppelt, dabei kann die entstehende Wärme auch als Nutzwärme für das Gebäude verwendet werden. Der erste Kühlkreislauf kann mit einer höheren Temperatur betrieben werden, beispielsweise kann die Soll-Temperatur am Vorlauf 50°C und am Rücklauf 60°C betragen. Aufgrund der hohen möglichen Vorlauftemperatur muss für die Kühlung nicht zwangsläufig auf eine Kältemaschine zurückgegriffen werden.

Der zweite Kühlkreislauf, umfassend die Luftkühlung, ist dagegen mit einer Kältemaschine (nicht dargestellt) verbunden, da dieser mit niedrigerer Temperatur betrieben werden muss, beispielsweise beträgt die Temperatur am Einlass maximal 20°C und am Auslass 35°C.

Da aber ein großer Teil der in Form von Wärme abzuführenden Energie über den ersten, flüssigkeitsbasierten Kühlkreislauf abgeführt werden kann, ergibt sich eine erhebliche Energieeinsparung bei dem System zur Kühlung einer Rechenanlagen.

Die eingesparte Energie errechnet sich aus der über den ersten Kühlkreislauf abgeführten Energiemenge geteilt durch den Wirkungsgrad (COP) der Kältemaschine.

Da Kältemaschinen in der Regel mit einem schlechten Wirkungsgrad arbeiten, ist die eingesparte Energie erheblich.

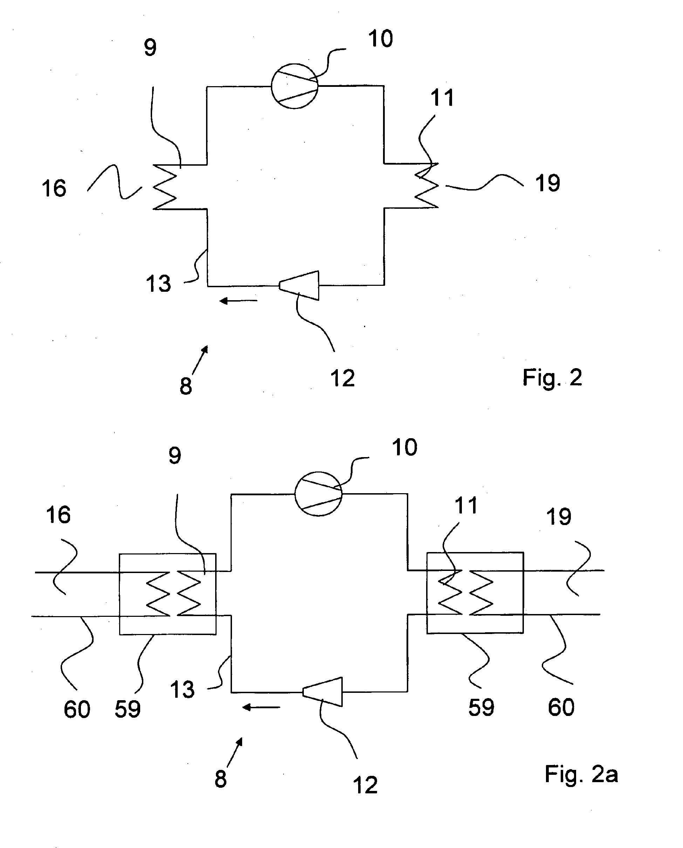

Bezugnehmen auf Fig. 2 soll schematisch das Prinzip einer Kältemaschine erläutert werden. Es handelt sich in diesem Ausführungsbeispiel um eine Kompressionskältemaschine.

Die Kältemaschine 8 umfasst einen Kältemittelkreislauf 13, welcher als der der kühlmaschineninterne Kältemittelkreislauf angesehen werden kann. Im Verdampfer 9 entspannt sich das Kältemittel, wird dabei gasförmig und sorgt für eine Temperaturherabsetzung. Der Verdampfer 9 bildet den Kaltteil der Kältemaschine. Über einen Kompressor 10 wird das Kältemittel über den Kühlkreislauf 13 einem Kondensator zugeführt. Unter Druckerhöhung verflüssigt sich das Kältemittel und kann am Kondensator Abwärme abgeben, um dem System Energie zu entziehen. Der Kondensator 11 bildet den Warmteil der Kältemaschine 8. Über das Expansionsventil 12 wird das Kältemittel wiederum dem Verdampfer zugeführt und es wird somit ein geschlossener Kreislauf gebildet.

Fig. 2a stellt schematisch eine Kühlmaschine dar, bei welcher der interne Kältemittelkreislauf 13 über einen internen Wärmetauscher 59 mit außerhalb der Kühlmaschine liegenden Kühlmittelanschlüssen verbunden ist.

Fig. 2 und Fig. 2a verdeutlichen somit die Möglichkeit, dass ein erfindungsgemäßer Kühlkreislauf auch so ausgeführt sein kann, dass er anstelle einer Kühlflüssigkeit (beispielsweise Wasser) das Kältemittel der Kältemaschine enthält, wobei die Kühlung direkt über den Verdampfer der Kältemaschine erfolgt. Das kann die Baugröße der Kältemaschine reduzieren, was insbesondere bei beispielsweise in Servern integrierten Kältemaschinen von Bedeutung sein kann.

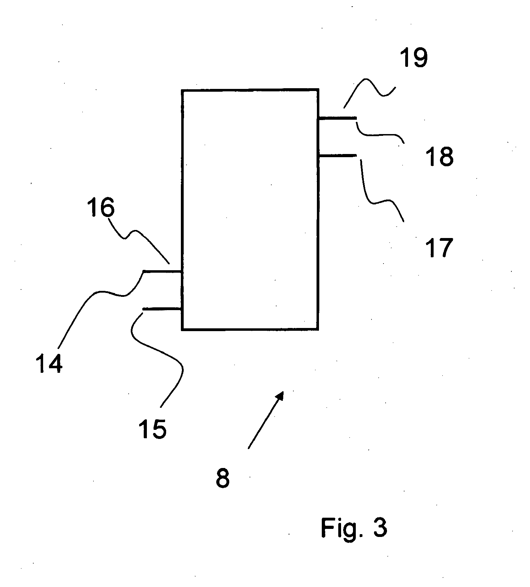

Bezug nehmend auf Fig. 3 sollen die thermischen Anschlüsse einer Kältemaschine erläutert werden. Die Kältemaschine 8 umfasst einen Kaltteil 16 mit einem Einlass 14 und einem Auslass 15. Über den Kaltteil 16 wird beispielsweise der zweite Kühlkreislauf eines Systems zur Kühlung einer Rechenanlage gekühlt.

Auch der Warmteil 19 umfasst einen Einlass 17 und einen Auslass 18. Am Warmteil kann beispielsweise eine Vorlauftemperatur von 50°C vorhanden sein, wohingegen beim Kaltteil die Rücklauftemperatur beispielsweise 15°C beträgt.

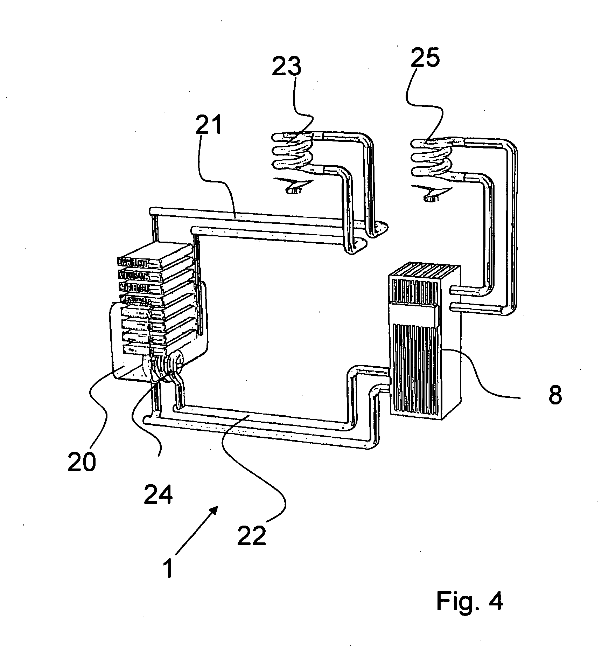

Fig. 4 zeigt ein schematisch dargestelltes Ausführungsbeispiel eines Systems zur Kühlung einer Rechenanlage 1.

Das System zur Kühlung einer Rechenanlage 1 umfasst einen ersten Kühlkreislauf 21.

Bei dem ersten Kühlkreislauf handelt es sich um einen flüssigkeitsbasierten Kühlkreislauf, mit dem in dem Rack 20 befindliche Prozessoren und Leistungsbauteile gekühlt werden.

Über den ersten Kühlkreislauf 21 wird Wärme über den Wärmetauscher 23 der Umgebung zugeführt. Es versteht sich, dass diese Wärme auch als Nutzwärme, oder zur Erzeugung von elektrischer Energie verwendet werden kann.

Weiter umfasst das System zur Kühlung einer Rechenanlage 1 einen zweiten Kühlkreislauf 22. Der zweite Kühlkreislauf 22 umfasst einen in dem Rack 20 integrierten bzw. an das Rack 20 angeschlossenen Wärmetauscher 24, mit welchem die Luft in dem Rack 20 in einem Rack-internen Luft-Kreislauf gekühlt wird. Der Kühlkreislauf 22 ist mit einer Kältemaschine 8 verbunden.

Der Kühlkreislauf 22 hat eine wesentlich geringere Vorlauftemperatur als der Kühlkreislauf 21. Es ist daher die Verwendung der Kältemaschine 8, welche insbesondere als Kompressionskältemaschine ausgebildet ist, notwendig, sofern nicht, wie bereits dargestellt, eine freie Kühlung verwendet werden kann.

Über den Warmteil der Kältemaschine 8 wird Abwärme, auch Prozesswärme genannt, über den Wärmetauscher 25 nach außen abgeführt.

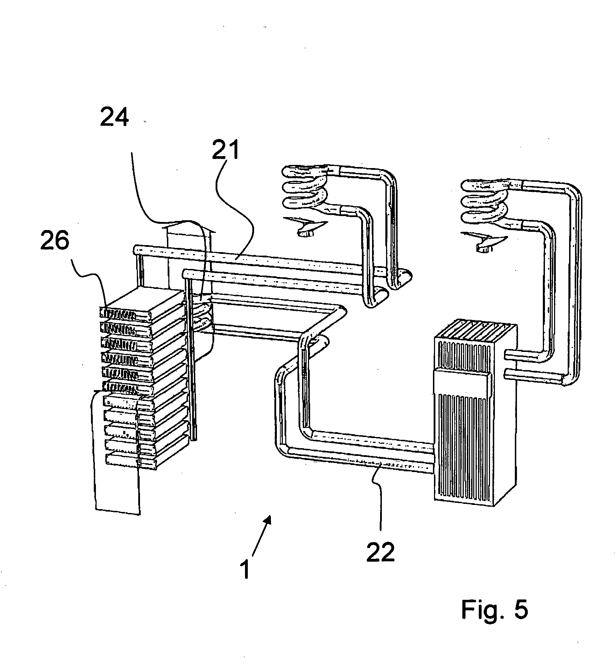

Fig. 5 zeigt ein weiteres Ausführungsbeispiels eines Systems zur Kühlung einer Rechenanlage 1. Auch hier umfasst das System einen ersten Kühlkreislauf 21, welcher wasserbasiert ist.

Im Unterschied zu dem in Fig. 4 dargestellten Ausführungsbeispiel wird die durch die Module 26 des Servers geführte Luft über einen mit dem zweiten Kühlkreislauf 22 verbundenen Wärmetauscher 24 nach Verlassen der Rechenanlage gekühlt. Es ist jedoch ebenso möglich, dass die Luft, anstelle vor Verlassen der Rechenanlage, vor Eintritt in die Rechenanlage gekühlt wird (nicht dargestellt).

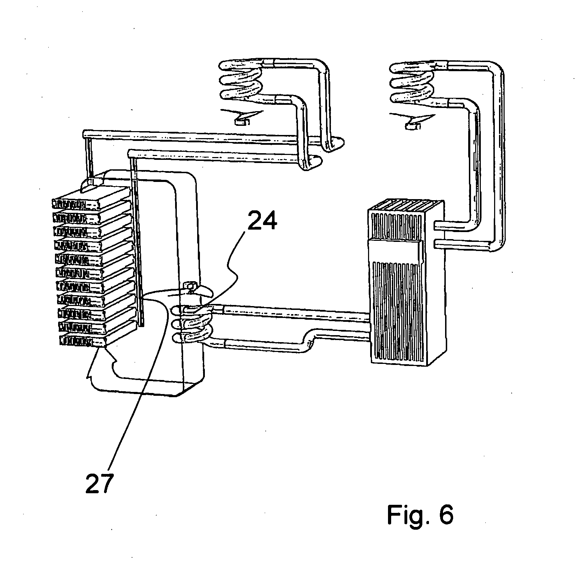

Fig. 6 zeigt ein weiteres Ausführungsbeispiel, bei welchem, im Unterschied zu den vorstehend genannten Ausführungsbeispielen, der mit dem zweiten Kühlkreislauf verbundene Wärmetauscher 24 außerhalb des Racks der Rechenanlage angebracht ist. Über einen Lüfter 27 kann die Luft in Bewegung gesetzt werden und der zweite Kühlkreislauf mit niedrigerer Vorlauftemperatur, beispielsweise über die Klimatisierung des Raumes, in welchem die Server stehen, realisiert werden.

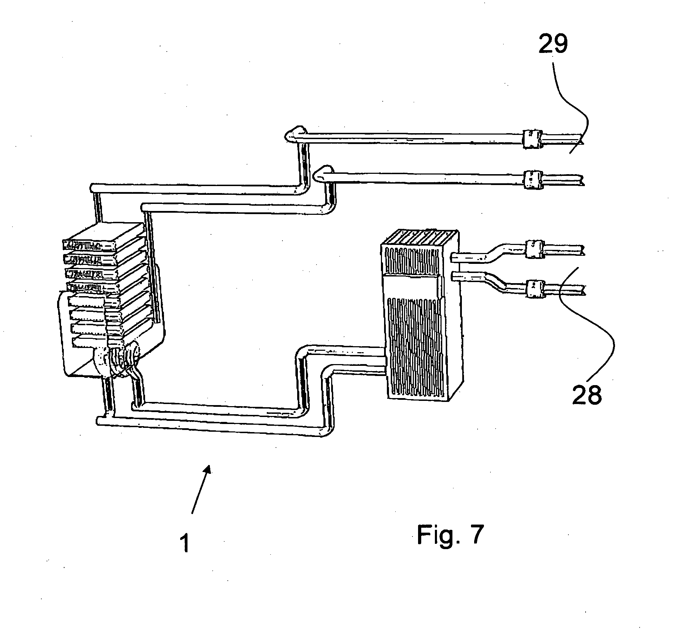

Fig. 7 zeigt ein weiteres Ausführungsbeispiel eines Systems zur Kühlung einer Rechenanlage 1, welches vom Prinzip her auf dem in Fig. 4 dargestellten Ausführungsbeispiel basiert. Statt externer Wärmetauscher ist hier sowohl die Kältemaschine mit einem Anschluss 28 als auch der erste Kühlkreislauf mit einem Anschluss 29 versehen, über welche die Wärme abgeführt und als Nutzwärme zur Verfügung gestellt werden kann, beispielsweise zur Gebäudeheizung, Warmwasserversorgung oder zur Erzeugung von elektrischer Energie.

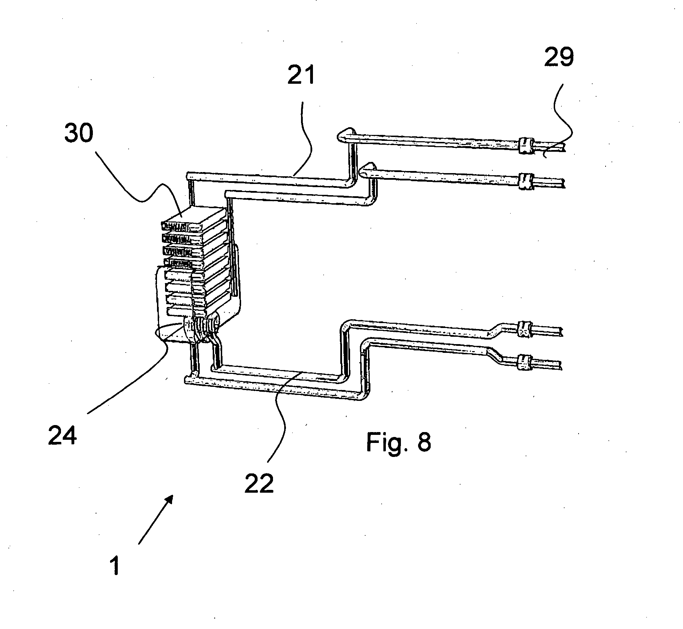

Fig. 8 zeigt ein Ausführungsbeispiel eines Systems zur Kühlung einer Rechenanlage 1, bei welchem auf eine Kältemaschine verzichtet werden kann.

Über einen ersten Kühlkreislauf 21 wird eine Flüssigkeitskühlung bereitgestellt, mit der die Prozessoren und Leistungsbauteile der Rechenanlage 30 gekühlt werden.

Über den Anschluss 29 kann die Wärme als Nutzwärme zur Verfügung gestellt werden (beispielsweise zur Gebäudeheizung, Warmwasserversorgung oder zur Erzeugung von elektrischer Energie) oder nach außen abgeführt werden.

Der zweite Kühlkreislauf 22 umfasst einen vorzugsweise im Rack der Rechenanlage 30 angeordneten Wärmetauscher 24, über welchen die Luft in dem Rack gekühlt wird. Als Kühlmedium kann aufgrund der geringen Menge an abzuführender Wärme beispielsweise Leitungswasser verwendet werden. Es versteht sich, dass beispielsweise auch denkbar ist, das Leitungswasser für die Warmwasserversorgung vorzuwärmen (zum Beispiel über Wärmetauscher - nicht dargestellt), so dass die dem zweiten Kühlkreislauf entnommene Energie, welche lediglich in einer Rücklauftemperatur von beispielsweise unter 30°C resultiert, genutzt werden kann.

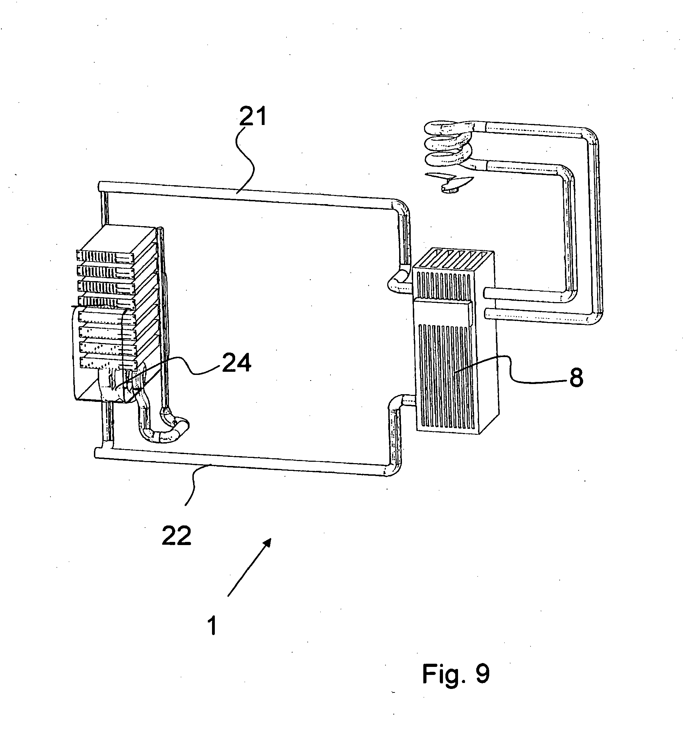

Fig. 9 zeigt ein weiteres Ausführungsbeispiel der Erfindung, bei welcher der zweite Kühlkreislauf 22 mit dem ersten Kühlkreislauf 21 verbunden ist.

In diesem Ausführungsbeispiel wird das von der Kältemaschine 8 gekühlte Kühlfluid zunächst dem Wärmetauscher 24 zugeführt, über den die Luft im Rack gekühlt wird.

Das so bereits erwärmte Kühlfluid wird sodann in den ersten Kühlkreislauf 21 weitergeleitet und kühlt die Prozessoren und Leistungsbauteile.

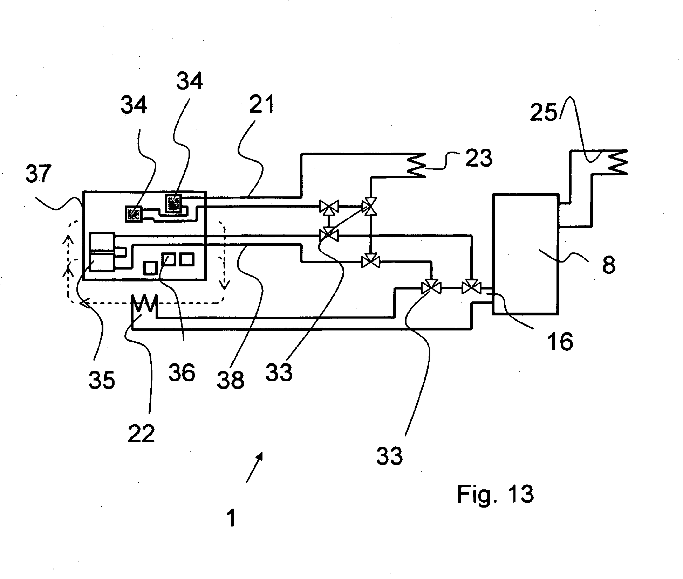

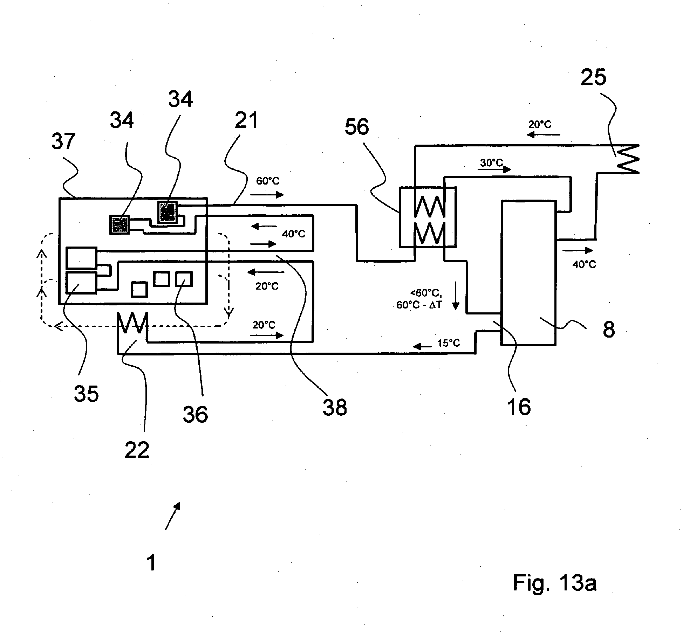

Die Kühlkreisläufe sind auf diese Weise hintereinander geschaltet, wobei die beispielsweise von einer Kältemaschine bereitgestellte Kühlflüssigkeit zuerst den Kühlkreislauf mit dem geringeren Temperaturniveau durchläuft, und danach den Kühlkreislauf mit dem höheren Temperaturniveau. Es versteht sich, dass auf diese Weise auch mehr als zwei Kühlkreisläufe hintereinandergeschaltet werden können, beispielsweise die in Fig. 13 dargestellten Kühlkreisläufe 21, 22 und 38 des Servers 37.

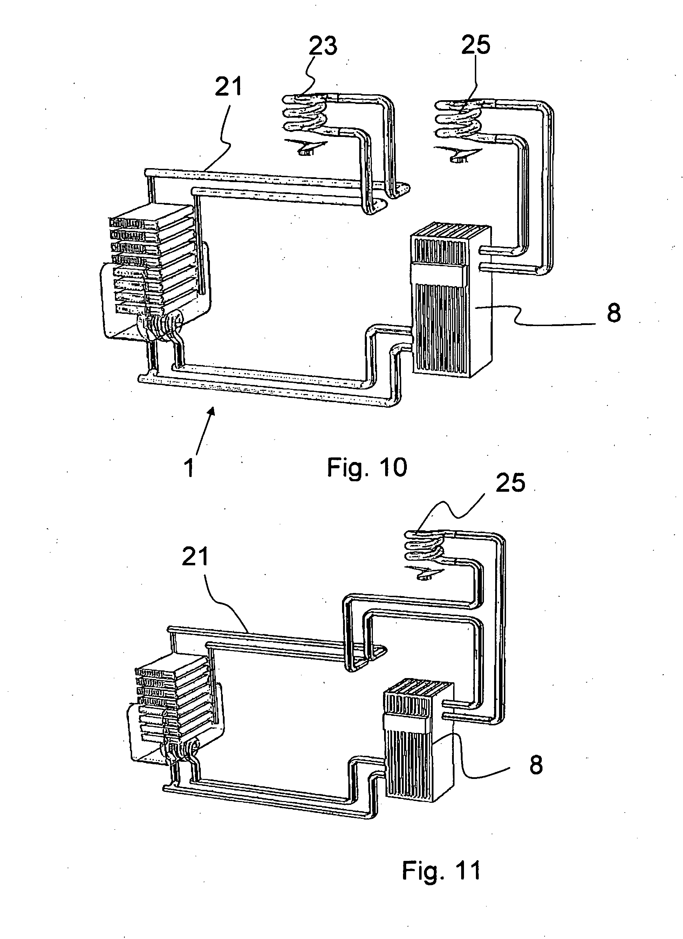

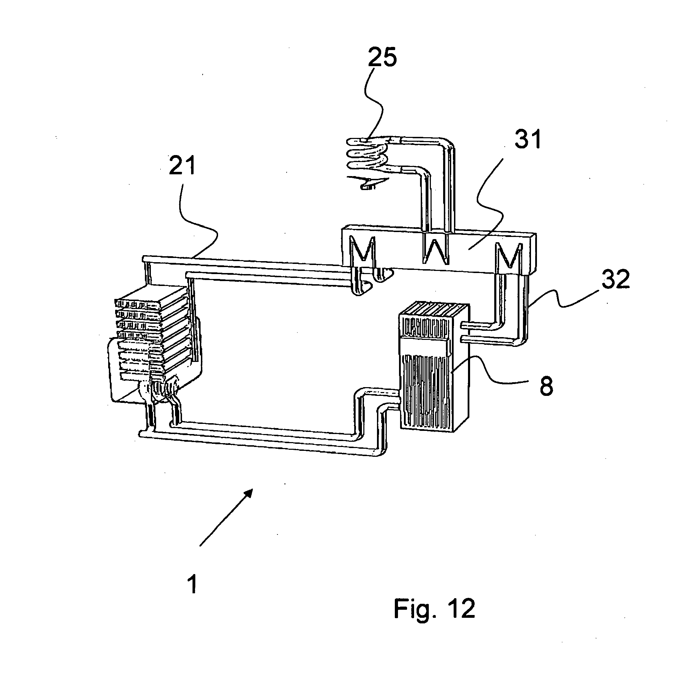

Bezug nehmend auf die Zeichnungen Fig. 10 bis Fig. 12 sollen verschiedene Möglichkeiten erläutert werden, die Abwärme abzuführen.

In dem in Fig. 10 dargestellten Ausführungsbeispiel eines Systems zur Kühlung einer Rechenanlage 1 ist der erste Kühlkreislauf 21 zur Kühlung der Prozessoren und Leistungsbauteile mit einem externen Wärmetauscher 23 verbunden. Der Warmteil der Kältemaschine 8 ist mit einem weiteren separaten Wärmetauscher 25 verbunden, über den Prozesswärme abgeführt wird.

Fig. 11 zeigt ein weiteres Ausführungsbeispiel, bei dem der Warmteil der Kältemaschine 8 mit dem ersten Kühlkreislauf 21 verbunden ist. Dies ist möglich, da für die Prozessoren die Bereitstellung eines Kühlfluids mit einer Temperatur von beispielsweise 50°C ausreicht.

Das dem Rücklauf des ersten Kühlkreislaufs 21 entnommene Fluid wird zunächst über einen Wärmetauscher 25 zugeführt und sodann dem Rücklauf des Kaltteils der Kältemaschine 8 zugeführt.

Diese Ausführungsform kann auch als sequentieller Kühlkreislauf bezeichnet werden.

Fig. 12 zeigt ein weiteres Ausführungsbeispiel eines Systems zur Kühlung einer Rechenanlage.

In diesem Ausführungsbeispiel ist ein zwischengeschalteter Wärmetauscher 31 vorgesehen. Mit dem Wärmetauscher 31 ist sowohl der erste Kühlkreislauf 21 zur Prozessorkühlung als auch ein Kühlkreislauf 32, welcher den Kühlkreislauf des Warmteils der Kältemaschine bildet, verbunden. Über den Wärmetauscher 31 werden diese Kühlkreisläufe thermisch zusammengeführt und an den extern angeordneten Wärmetauscher 25 angekoppelt.

Diese Ausführungsform der Erfindung hat den Vorteil, dass mithin nur noch zwei Anschlüsse zum Anschluss eines extern angeordneten Wärmetauschers 25 erforderlich sind. Aufgrund eines maximalen Temperaturunterschiedes von 20°C, vorzugsweise 10°C im ersten Kühlkreislauf 21 und im Kühlkreislauf der Kältemaschine 32, ist dies auf besonders einfache Weise möglich.

Bezug nehmend auf Fig. 13 bis Fig. 15 soll anhand eines schematisch dargestellten Ausführungsbeispiels ein System zur Kühlung einer Rechenanlage 1 mit drei Kühlkreisläufen näher erläutert werden.

Bezug nehmend auf Fig. 13 sollen die wesentlichen Komponenten des Systems zur Kühlung einer Rechenanlage 1 erläutert werden.

Das System zur Kühlung einer Rechenanlage 1 umfasst eine erste Gruppe wärmeerzeugender Komponenten 34, welche mit einem ersten Kühlkreislauf 21, der flüssigkeitsbasiert ist, verbunden sind.

Eine zweite Gruppe wärmeerzeugender Komponenten 35, welche ebenfalls in dem Server 37 vorhanden ist, ist ebenfalls mit einer Flüssigkeitskühlung ausgestattet. Dieser zusätzliche Kühlkreislauf wird im Folgenden als dritter Kühlkreislauf 38 bezeichnet.

Eine dritte Gruppe wärmeerzeugender Komponenten 36 wird von wärmeerzeugenden Bauteilen gebildet, welche nicht mit einer Flüssigkeitskühlung verbunden sind.

Diese Komponenten 36 werden durch Luftkühlung über einen zweiten Kühlkreislauf 22, welcher einen in dem Rack angeordneten Wärmetauscher umfasst, gekühlt.

Weiter ist eine Kältemaschine 8 mit einem Kaltteil 16 vorgesehen, über welches zumindest der zweite Kühlkreislauf 22 gekühlt wird. Der Warmteil der Kältemaschine 8 ist mit einem externen Wärmetauscher verbunden.

Weiter ist noch ein weiterer externer Wärmetauscher 32 vorhanden, über den Abwärme nach außen abgeführt werden kann.

Sinn dieses Systems ist es nunmehr, dass drei Kühlkreisläufe vorhanden sind, welche mit unterschiedlicher Vorlauftemperatur arbeiten. Die niedrigste Vorlauftemperatur benötigen die luftgekühlten Bauteile der dritten Gruppe wärmeerzeugender Komponenten 36. Die der ersten Gruppe wärmeerzeugender Komponenten 34 zugeordneten Prozessoren und Leistungsbauteile werden mit der höchsten Vorlauftemperatur, insbesondere mit einer Vorlauftemperatur von über 50°C gekühlt.

Es ist daher in der Regel möglich, zumindest bei der ersten Gruppe wärmeerzeugender Komponenten 34 auf die Zuhilfenahme einer Kältemaschine weitgehend oder ganz zu verzichten und diese über den externen Wärmetauscher 23 zu kühlen.

In Fig. 13 ist eine Konfiguration dargestellt, in der bei der ersten Gruppe wärmeerzeugender Komponenten 34 auf die Zuhilfenahme einer Kältemaschine ganz verzichtet ist.

Die zweite Gruppe wärmeerzeugender Komponenten 35 wird mit einer Vorlauftemperatur gekühlt, welche zwischen dem ersten Kühlkreislauf 21 und dem zweiten Kühlkreislauf 22 liegt.

Über Ventile 33 kann nunmehr das Kühlfluid des dritten Kühlkreislaufs 38 variabel auf den Wärmetauscher 23 und den Kaltteil 16 der Kältemaschine 8 verteilt werden.

Je nach benötigter Kühlleistung und vorhandener Außentemperatur ist es nunmehr möglich, zur Kühlung des dritten Kühlkreislaufs 38 nur dann auf die Kältemaschine 8 zurückzugreifen, wenn dies beispielsweise aufgrund hoher Außentemperaturen erforderlich ist.

Es versteht sich, dass auf ähnliche Weise auch der erste Kühlkreislauf je nach benötigter Kühlleistung und vorhandener Außentemperatur variabel auf den Wärmetauscher 23 und den Kaltteil der Kältemaschine 8 verteilt werden kann (nicht dargestellt).

Fig.13 verdeutlicht somit weiterhin, dass über Ventile und (nicht dargestellte Pumpen) zumindest zwei Kühlkreisläufe variabel auf den Wärmetauscher 23 und den Kaltteil der Kältemaschine 8 verteilt werden können.

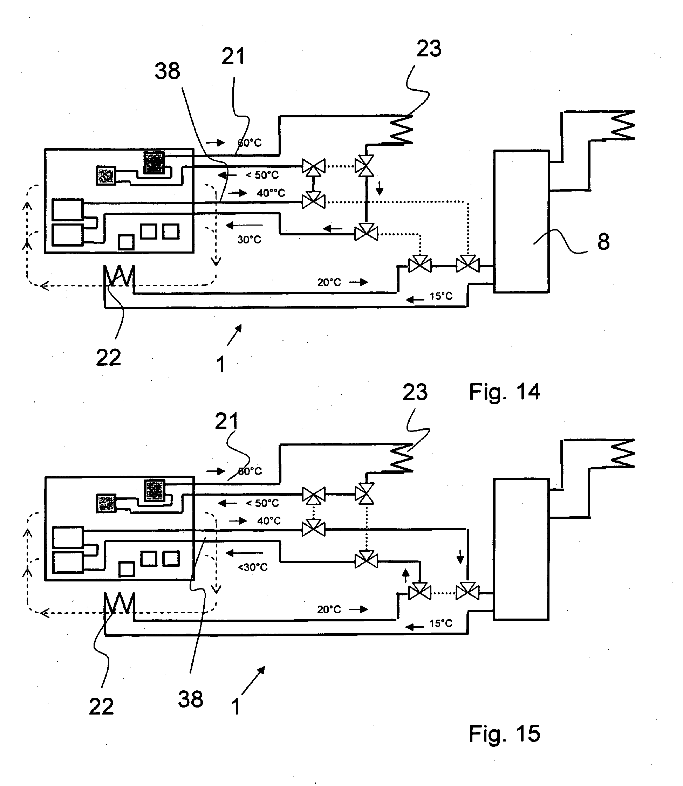

Fig. 14 zeigt das in Fig. 13 dargestellte System zur Kühlung einer Rechenanlage 1 in einem Betriebszustand bei einer Außentemperatur von unter 30°C, beispielsweise unter 30°C und über 10°C. Die jeweiligen Temperaturen der Vorläufe und Rückläufe sind beispielhaft eingezeichnet.

Zu erkennen ist, dass sowohl der erste Kühlkreislauf 21 als auch der dritte Kühlkreislauf 38 über die Ventile derart geschaltet sind, dass diese Kühlkreisläufe mit dem Wärmetauscher 23 verbunden sind.

Mithin muss lediglich der zweite Kühlkreislauf 22 über die Kältemaschine 8 versorgt werden.

Fig. 15 zeigt einen Betriebszustand des Systems zur Kühlung einer Rechenanlage 1, bei einer Außentemperatur von über 30°C, beispielsweise über 30°C und unter 50°C. In diesem Betriebszustand ist nunmehr nur noch der erste Kühlkreislauf 21 mit dem Wärmetauscher 23 verbunden. Da die Außentemperatur nicht mehr genügt, um das Fluid des dritten Kühlkreislaufs 38 auf eine hinreichend niedrige Temperatur zu bringen, ist nunmehr auch der Kühlkreislauf 38 mit dem Kaltteil der Kältemaschine verbunden. Die Kältemaschine kühlt somit den dritten Kühlkreislauf 38 sowie den zweiten Kühlkreislauf 22.

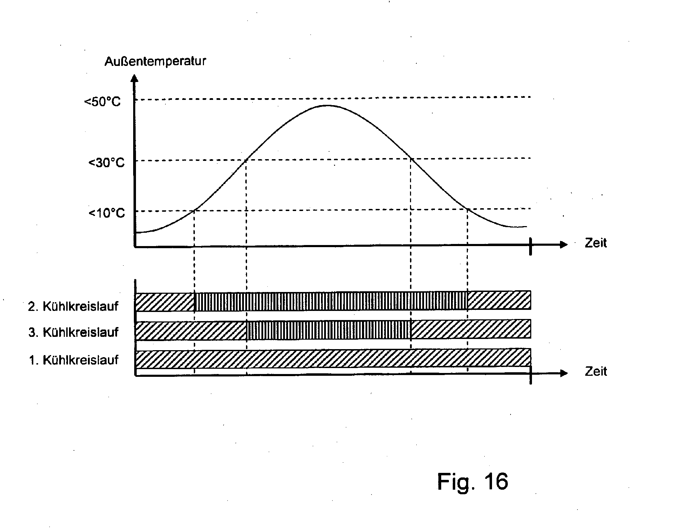

Bezug nehmend auf Fig. 16 soll der Effekt des vorstehend beschriebenen Ausführungsbeispiels zur Kühlung einer Rechenanlage näher erläutert werden.

In Fig. 16 ist oben eine Kurve aufgetragen, welche die Temperatur in Abhängigkeit von der Zeit wiedergibt. Die Zeit ist dabei auf der X-Achse und die Temperatur auf der Y-Achse wiedergegeben.

Es kann sich dabei sowohl um ein Temperaturprofil eines Tages als auch um das Temperaturprofil der mittleren Temperatur in einem Jahr handeln.

Unter der Temperaturkurve ist aufgetragen, wann auf die Kältemaschine zurückgegriffen werden muss. Zeiten in denen auf die Kältemaschine zurückgegriffen werden muss, sind mit senkrechten Strichen gekennzeichnet, während die Phase in welcher über einen externen Wärmetauscher gekühlt werden kann, mit schrägen Linien gekennzeichnet ist.

Zu erkennen ist, dass der erste Kühlkreislauf die gesamte Zeit über ohne Verwendung der Kältemaschine betrieben werden kann.

Der zweite Kühlkreislauf, also der Kühlkreislauf, welcher von den drei Kühlkreisläufen mit geringster Vorlauftemperatur betrieben wird, muss dagegen über eine erhebliche Zeitspanne mithilfe der Kältemaschine betrieben werden, es kann beispielsweise nur nachts und/oder nur im Winter auf die Verwendung der Kältemaschine verzichtet werden.

Durch den zusätzlichen dritten Kühlkreislauf mit einer zwischen den Vorlauftemperaturen des ersten und zweiten Kühlkreislaufs liegenden Vorlauftemperatur wird die Effizienz des Systems weiter verbessert. Dieser Kühlkreislauf braucht nur bei einer Temperatur von über 30°C mit der Kältemaschine betrieben zu werden.

Fig. 13a zeigt beispielhaft ein System zur Kühlung einer Rechenanlage. Der Server 37 und dessen drei Kühlkreisläufe 21, 22 und 38, für die Komponenten 34, 36 und 35 des Servers 37, sind in Fig. 13 beschrieben.

Im Unterschied zu Fig. 13 zeigt die Fig. 13a jedoch eine Konfiguration welche freie Kühlung einschließt, also Kühlung ohne die Verwendung einer Kältemaschine, die hier beispielhaft und schematisch anhand der angegebenen Temperaturen erläutert werden soll.

Die drei Kühlkreisläufe des Servers sind in diesem Beispiel hintereinandergeschaltet, zunächst der Kühlkreislauf 22, mit einer Einlasstemperatur von 15°C und einer Auslasstemperatur von 20°C. Dieser Kühlkreislauf 22 ist verbunden mit dem Kühlkreislauf 38, mit einer Einlasstemperatur von 20°C und einer Auslasstemperatur von 40°C. Dieser Kühlkreislauf 38 wiederum ist verbunden mit dem Kühlkreislauf 21, mit einer Einlasstemperatur von 40°C und einer Auslasstemperatur von 60°C. In Reihenschaltung dieser 3 Kreisläufe ergibt sich somit insgesamt eine Einlasstemperatur von 15°C (Einlass Kreislauf 22), und eine Auslasstemperatur von 60°C (Auslass Kreislauf 21). Der Rückkühler 25 stellt in diesem Beispiel eine Auslasstemperatur der Kühlflüssigkeit von 20°C bereit. Diese wird zunächst zu einem Wärmetauscher für freie Kühlung 56 geleitet, und kühlt die Auslasstemperatur des Kühlkreises 21 von 60°C auf 60°C - ΔT, bevor diese zum Einlass des Kälteteils 16 der Kühlmaschine 8 geleitet wird. Es verringert sich somit die durch die Kältemaschine 8 zu erbringende Kühlleistung.

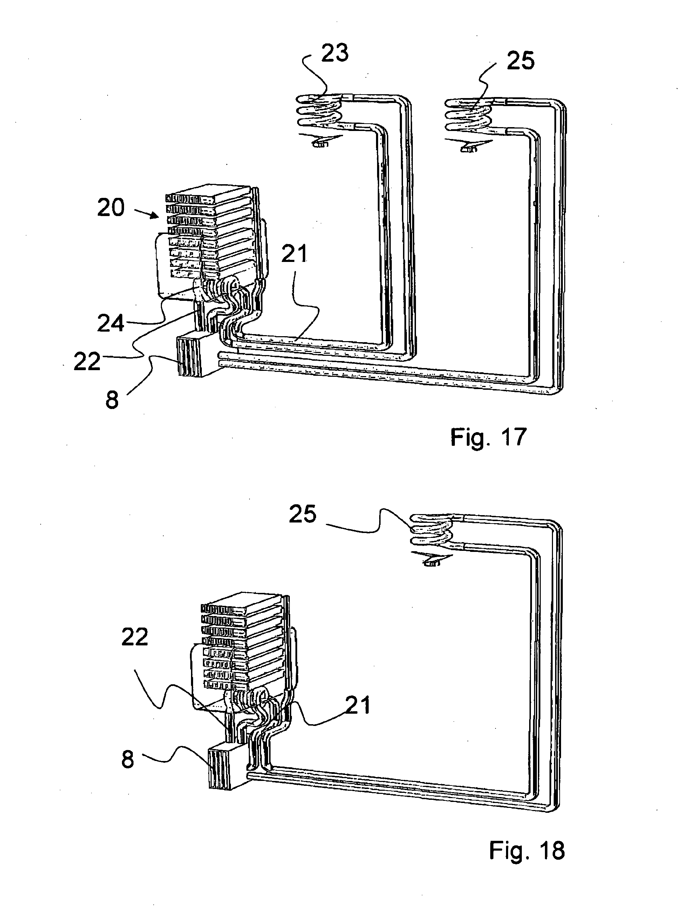

Fig. 17 zeigt eine Ausführungsform der Erfindung, bei der eine Kältemaschine 8, insbesondere eine Kompressionskältemaschine, in einem Rack 20 integriert ist, bzw. unmittelbar benachbart zum Rack 20 angeordnet ist (nicht dargestellt). Die Kältemaschine 8 ist mit einem Wärmetauscher 24 verbunden, durch den der zweite Kühlkreislauf zur Kühlung der in dem Rack befindlichen Luft gebildet wird.

Prozesswärme wird über den Warmteil der Kältemaschine 8 und über den Wärmetauscher 25 abgeführt.

Prozessoren und Leistungsbauteile sind mit einem ersten Kühlkreislauf 21 verbunden, wobei die Wärme über den Wärmetauscher 23 nach außen abgeführt wird.

Fig. 18 zeigt ein weiteres Ausführungsbeispiel, bei dem ebenfalls die Kältemaschine 8 im oder am Rack angeordnet ist.

Hier wird auf die vorstehend bezeichnete sequentielle Kühlung zurückgegriffen, bei welcher der Rücklauf des Warmteils der Kältemaschine 8 mit dem ersten Kühlkreislauf 21 gekoppelt ist.

Das Kühlfluid wird also zunächst vom Rücklauf des Warmteils der Kältemaschine 8 über die Prozessoren und Leistungsbauteile geführt.

Sodann wird über einen externen Wärmetauscher 25 dem System Energie entzogen und das Kühlfluid wiederum dem Warmteil der Kältemaschine 8 zurückgeführt.

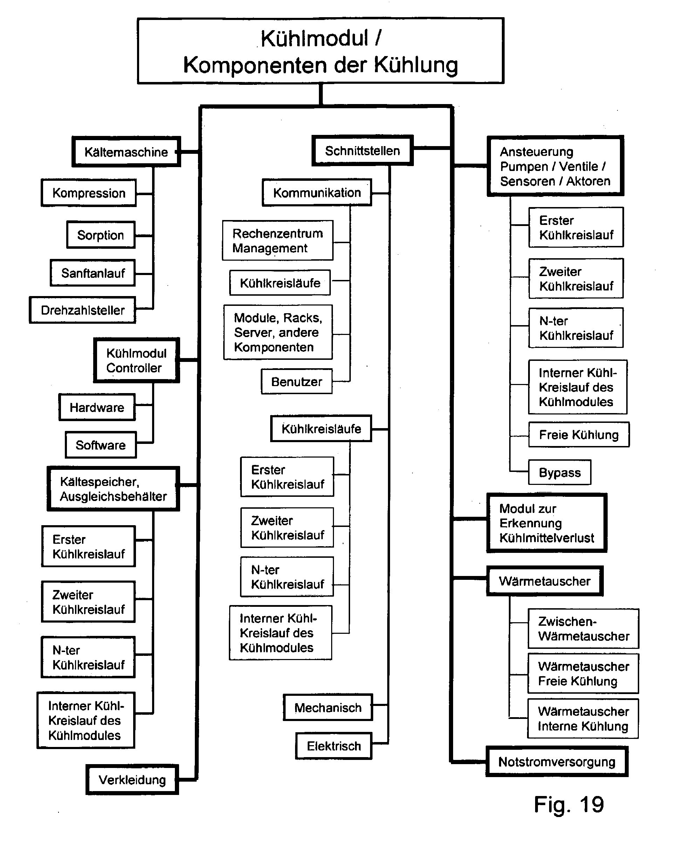

Fig. 19 zeigt eine Übersicht der Komponenten eines Kühlmodules.

Das Kühlsystem ist insbesondere modular ausgebaut, um eine einfache Adaption an die Racks oder andere Komponenten des Rechencenters zu erreichen.

Die möglichen Komponenten eines Kühlmoduls sind in dem in Fig. 19 dargestellten Organigramm gezeigt. Ein Kühlmodul kann auch eine Untermenge der dargestellten Komponenten erfassen. Die Komponenten können als Kühlmodul ausgeführt sein, oder auch nicht modular.

Insbesondere die Kältemaschine ist dabei nicht zwangsweise Bestandteil des Kühlmodules, sie kann auch außerhalb der Kühlmodule angeordnet sein, oder nur in einem Kühlmodul für mehrere Racks, welche wiederum ein oder je ein weiters Kühlmodul mit den anderen Komponenten umfassen.

Das Kühlsystem ist insbesondere modular ausgebaut, um eine einfache Adaption an die Racks oder andere Komponenten des Rechencenters zu erreichen.

Ein Kühlmodul kann auch eine Untermenge der dargestellten Komponenten erfassen. Die Komponenten können als Kühlmodul ausgeführt sein, oder auch nicht modular. Es versteht sich somit, dass das System, soweit technisch sinnvoll, aus einer beliebigen Kombination folgender Komponenten bestehen kann.

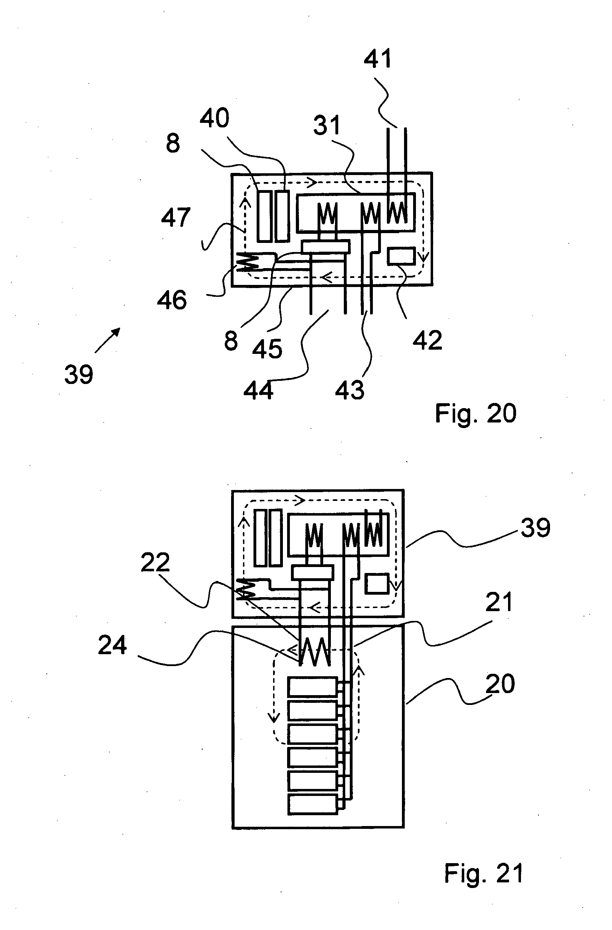

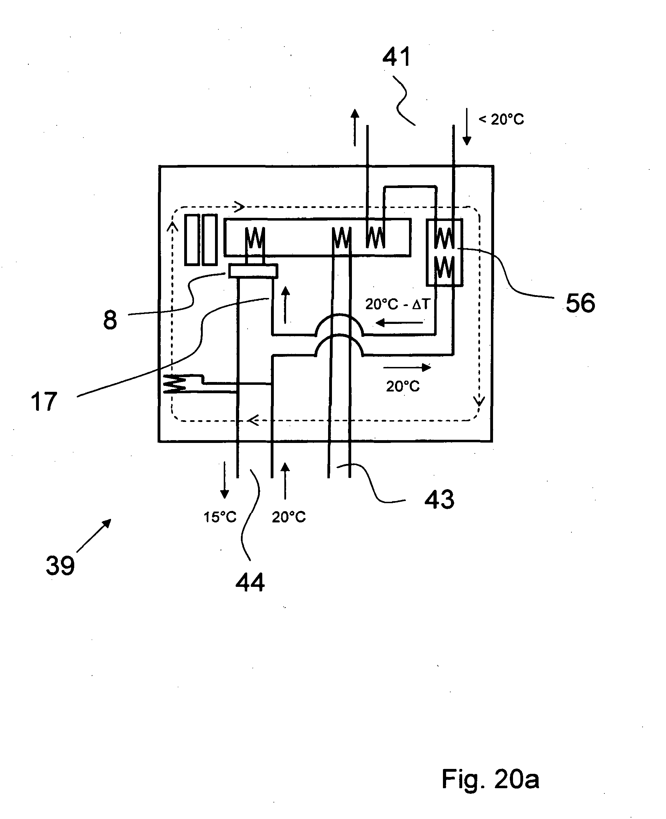

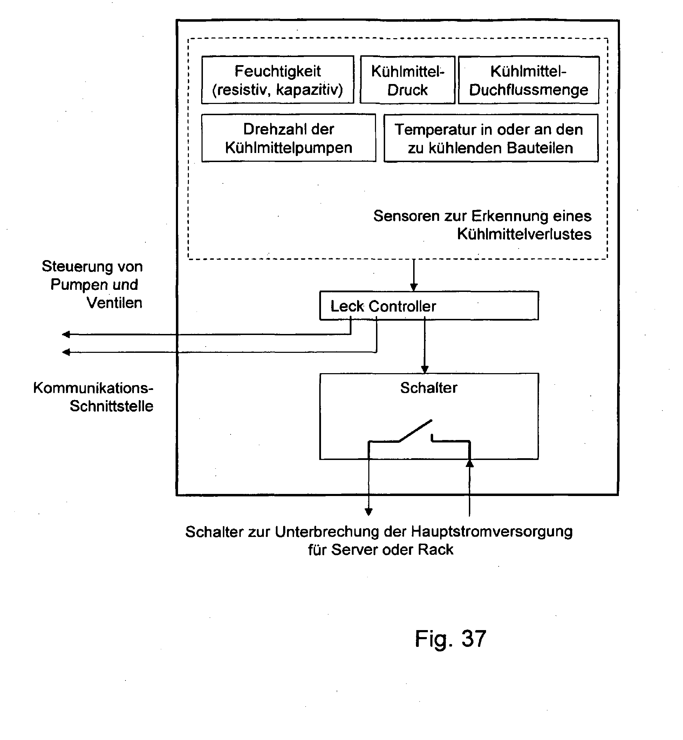

Die einzelnen Komponenten sind insbesondere wie folgt definiert:
- Kältemaschine: Umfasst eine Kompressions-Kältemaschine, oder eine Sorptions-Kältemaschine, oder eine auf dem magnetokalorischen Effekt oder Peltier-Elementen basierende Kältemaschine. Um hohe Anzahl von Schaltzyklen zu erreichen (eine hohe Anzahl von Schaltzyklen reduziert die Größe eines je nach Ausführung des Kühlmodules eingesetzten Kältespeichers), ohne die Lebensdauer der je nach Typ der der eingesetzten Kältemaschinen verwendeten Motoren zu reduzieren, kann für die Kompressionskältemaschine eine Sanftanlaufschaltung eingesetzt werden. Weiterhin kann eine elektronische Drehzahleinstellung verwendet werden, was anstelle einer digitalen Ein-Aus-Steuerung des Kompressormotors, wobei die Menge der bereitgestellten Kühlenergie durch das Verhältnis von Ein-Aus-Zyklen bestimmt wird, eine analoge Steuerung der Drehzahl des Kompressormotors und damit der Menge der bereitgestellten Kühlenergie über diese elektronische Drehzahleinstellung ermöglicht.
- Controller: Umfasst Hardware und Software. Über den Controller erfolgt die Steuerung aller Komponenten des Kühlmodules. Weiterhin erfolgt über den Controller (oder kann über den Controller erfolgen) beispielsweise die Regelung der Temperaturen der Kühlkreisläufe, oder die Regelung der durch den Kompressor bereitgestellten Kälteenergiemenge, oder die Regelung der in den einzelnen Kühlkreisläufen übertragenen Kälteenergiemenge. Die in den einzelnen Kühlkreisläufen bereitgestellte Kälteenergiemenge kann beispielsweise gesteuert werden durch die Temperatur des Kühlfluids (bei gleichem Volumenstrom wird beispielsweise durch eine Absenkung der Austrittstemperatur des Kaltteiles der Kühlmaschine mehr Kälteenergie übertragen), oder durch den Volumenstrom (bei gleichen Eintritts- und Austrittstemperaturen des Kaltteiles der Kühlmaschine wird durch Erhöhung des Volumenstromes des Kühlfluids mehr Kälteenergie übertragen).
- Kältespeicher, Ausgleichsbehälter: Der Kältespeicher ist je nach Ausführungsform notwendig, um die Zeitkonstante zwischen Anschalten des Kompressors und Bereitstellung von Kälteenergie zu überbrücken, und um insbesondere Temperaturschwankungen im Kühlkreislauf zu reduzieren. Weiterhin beeinflusst der Kältespeicher die Zahl der Anschaltvorgänge während des Betriebes bei einer Steuerung der Kältemenge durch Ein-Aus-Zyklen des Kompressors, und damit die Lebensdauer der Kältemaschine. Der Kältespeicher ist nur einmal pro Kältemaschine notwendig. Der Kältespeicher kann auch als Sorptionskältespeicher oder als ein auf Phasenwechselmaterialien basierender Latentkältespeicher ausgeführt sein, der über (nicht dargestellte Wärmetauscher) mit dem Kühlfluid verbunden ist. Ausgleichsbehälter sind notwendig zur Befüllung der Kühlkreisläufe mit Flüssigkeit.
- Schnittstellen: Das Kühlmodul oder Komponenten des Kühlmodules verfügen über trennbare oder steckbare Schnittstellen für die Kommunikationsschnittstellen, die Schnittstellen für die Verbindung der Kühlkreisläufe (Kühlflüssigkeiten), sowie für die elektrischen Schnittstellen. So kann beispielsweise das Kühlmodul oder Komponenten desselben als steckbare 19"-Komponente ausgeführt sein, wobei die Leitungen für die Kommunikation, die Kühlflüssigkeit oder die elektrischen Anschlüsse beim Stecken automatisch verbunden werden. Alternativ ist es möglich, diese Leitungen über schnell trennbare Verbindungen auszuführen. Somit wird ein modularer und servicefreundlicher Aufbau unterstützt.
   ○ Kommunikationsschnittstellen: Eine Kommunikationsschnittstelle, beispielsweise Ethernet oder LAN, verbindet das Kühlmodul mit dem Management des Datencenters, beispielsweise zur Übermittlung des Betriebszustandes des Kühlmodules oder zur Koordination von Maßnahmen im Fehlerfall, z.B. Kühlmittelverlust. Das Kühlmodul kann weiterhin mit den Kühlkreisläufen verbunden sein (beispielsweise mit der Steuerung der Rack-Kühlung), sowie den Komponenten (beispielsweise den Servern, zur Koordination und Optimierung der Bereitstellung von Kühlenergie. Eine Benutzerschnittstelle kann beispielsweise optisch oder akustisch dem Personal des Rechenzentrums den Betriebszustand den Betriebszustand anzeigen.
   ○ Schnittstellen für Kühlkreisläufe: Das beinhaltet die Verbindungen zwischen dem Kühlmodul oder Komponenten desselben zu den Kühlkreisläufen gemäß der Erfindung. Die Schnittstellen können als selbstschließende Verbindungen ausgeführt sein, welche ein Auslaufen oder Austropfen geöffneter Leitungen für das Kühlmittel-Fluid verhindern oder zumindest verringern.
   ○ Elektrische Schnittstellen: Diese Schnittstellen beinhalten alle Schnittstellen der Stromversorgung sowie zu den Pumpen, Ventilen, Sensoren und anderen zum Kühlsystemen gehörenden Komponenten, die außerhalb des Kühlmodules liegen.
   ○ Mechanische Schnittstellen: Diese Schnittstellen beinhalten Form, Abmessungen und Befestigungselemente des Kühlmodules, welche einen modularen Einsatz des Kühlmodules oder Komponenten desselben im System zur Kühlung einer Rechenanlage ermöglichen. Beispielsweise kann das Kühlmodul oder Komponenten desselben in 19"-Bauweise ausgeführt sein, so dass es ähnlich wie Server oder Blade Server in einem Rack angebracht werden kann. Weiterhin kann die mechanische Schnittstelle so ausgeführt sein, dass das Kühlmodul oder Komponenten desselben angrenzend zu einen oder mehreren Racks angebracht werden können, und dabei die Systemabmessungen der Racks einhalten.
- Ansteuerung der Pumpen / Ventile / Sensoren / Aktoren: Diese Komponenten beinhalten alle Bauteile zur Ansteuerung der Pumpen, Ventile, Sensoren und Aktoren (beispielsweise Leistungselektronik zur Ansteuerung der Pumpen und Ventilen, die Elektronik zum einlesen von Temperatursensoren), sowohl für die Kühlkreisläufe der Rechenanlage, als auch für den internen Kühlkreislauf des Kühlmoduls, wie in Fig. 20 erläutert.
- Modul zur Erkennung von Kühlmittelverlust: Diese Komponente ist in Fig. 37 erläutert.
- Wärmetauscher: Diese Komponenten beinhalten die Wärmetauscher für die Rückkühlung, die freie Kühlung sowie die interne Kühlung.
- Verkleidung: Die Verkleidung gewährleistet die Einhaltung der je nach Ausführung des Kühlmoduls zutreffenden Sicherheitsbestimmungen. Weiterhin verhindert die Verkleidung (oder kann verhindern), gegebenenfalls durch eine zusätzliche thermische Isolierung, dass keine Abwärme des Kühlmoduls, beispielsweise vom Kompressormotor oder der Leistungselektronik, nach außen abgegeben wird, sondern dass das Kühlmodul nach außen thermisch neutral ist.
- Notstromversorgung: Im Fall eines Stromausfalles kann eine beispielsweise auf einem Akkumulator basierende Notstromversorgung den Betrieb des Kühlmoduls eine zeitlang aufrecht erhalten, und damit die Gefahr einer Überhitzung der Rechenanlage durch Stromausfall reduzieren.
- Weiter kann ein Kühlmodul mit einem Mittel zur Kondensatabführung versehen sein. So kann das einer kalten Stelle des Kühlmoduls und/oder eines Wärmetauschers der Rechenanlage anfallende Kondensat abgeführt werden. Je nach Menge kann dies die Verdunstung des Kondensats, beispielsweise am Warmteil der Kältemaschine oder die Abfuhr des flüssigen Kondensats umfassen.
- Beheizung: Bei einer weiteren Ausführungsform umfasst das Kühlmodul zumindest ein Heizelement, um beispielsweise über eine Rackkühlung die Rechenanlage zu erwärmen. Dies kann beispielsweise sinnvoll sein, um nach einer Abschaltung von Komponenten oder bei sehr geringer Auslastung eine unerwünscht niedrige Temperatur zu vermeiden. So kann die Gefahr von Kondensation in den Racks oder derartig niedrigen Temperaturen, für die die Komponenten der Rechenanlage nicht ausgelegt sind, reduziert werden. Zur Beheizung können alle Kühlkreisläufe verwendet werden. Als weitere Variante ist es möglich, die thermische Energie eines Kühlkreislaufes zu nutzen, um einen anderen Kühlkreislauf zu beheizen, beispielsweise kann über ein System von Ventilen und/oder Pumpen der erste Kühlkreislauf zur Prozessorkühlung mit dem zweiten Kreislauf der Rackkühlung so verbunden werden, dass der erste Kühlkreis zumindest einen Teil seiner thermischen Energie zumindest zeitweise in den zweiten Kühlkreislauf abgibt. Dadurch wird weniger Energie zur Beheizung benötigt, weiterhin kann ggf. auf ein weiteres, in der Regel elektrisches, Heizelement verzichtet werden.

Fig. 20 zeigt ein beispielhaftes Ausführungsbeispiel eines Kühlmoduls 39, welches beispielsweise an oder in einem Server oder Rack (nicht dargestellt) angebracht werden kann.

Das Kühlmodul 39 umfasst ein Gehäuse 45 mit einer Kältemaschine 8 und einem Controller 40, über den das Kühlmodul gesteuert wird.

Weiter umfasst das Kühlmodul 39 einen Anschluss für die Prozessorkühlung 43 bzw. die Versorgung eines ersten Kühlkreislaufs.

Weiter ist ein Anschluss 44 vorgesehen, an dem die Rackkühlung zur Bereitstellung eines zweiten Kühlkreislaufs angeschlossen werden kann.

Wie in einem vorherigen Ausführungsbeispielen beschrieben, ist ein zwischengeschalteter Wärmetauscher 31 vorgesehen, über den sowohl Prozesswärme über die Kältemaschine 8 als auch Wärme des ersten Kühlkreislaufs zusammengeführt und über den Anschluss 41 abgeführt werden kann.

Das Kühlmodul 39 umfasst selbst einen internen Wärmetauscher 46, um das Kühlmodul zu kühlen. Der Luftstrom 47 ist mit Pfeilen angedeutet. In diesem Kühlkreislauf wird die Abwärme des Kühlmodules selber gekühlt. Diese Abwärme wird durch die Komponenten des Kühlmodules erzeugt (zum Beispiel die durch den Motor der Kompressions-Kältemaschine oder den Controller). Durch die interne Kühlung des Kühlmodules ist das Kühlmodul nach außen thermisch neutral.

Das Kühlmodul kann ebenso über eine vorhandene Rackkühlung gekühlt werden, beispielsweise durch im Rack vorhandene Luftzirkulation.

Weiter umfasst das Kühlmodul eine Leck-Detektion (ein Modul zur Erkennung von Kühlmittelverlusten) 42, wie in Fig. 37 beschrieben, beispielsweise in Form einer Drucküberwachungsvorrichtung und/oder Feuchtigkeitssonde.

Es versteht sich, dass das Kühlmodul 39 noch weitere Komponenten, wie elektronische Schnittstellen und weitere Kühlanschlüsse, mechanische Anschlüsse, beispielsweise um in ein 19" Racksystem geschoben zu werden etc., umfassen kann.

Fig. 20a zeigt ein beispielhaftes Ausführungsbeispiel eines Kühlmoduls 39, welches beispielsweise an oder in einem Server oder Rack (nicht dargestellt) angebracht werden kann. Im Unterschied zu Fig. 20 ist hier die zusätzliche Baugruppe für freies Kühlen dargestellt und soll hier beispielhaft anhand der in der Figur angegebenen Temperaturen erläutert werden.

Im Fall, dass die Einlasstemperatur am Anschluss 41 (Rückkühlung) wie dargestellt beispielsweise <20°C beträgt, und die Einlasstemperatur am Anschluss 44 (Rackkühlung) beispielsweise 20°C beträgt, kann das Kühlmittel am Einlass von Anschluss 44, bevor es zur Kältemaschine 8 geführt wird, bereits über den Wärmetauscher 56 vorgekühlt werden. Dadurch muss das Kühlmittel durch die Kühlmaschine nicht mehr von 20°C auf 15°, also um 5 K gekühlt werden, sondern um 5K - ΔT. Es verringert sich somit die zu erbringende Kühlleistung der Kühlmaschine, und damit der Energieaufwand zur Kühlung.

Es versteht sich, dass das Prinzip der freien Kühlung nicht nur wie dargestellt im Kühlmodul, sondern im gesamten Kühlsystem entsprechend der Erfindung anwendbar ist. Weiterhin kann das Prinzip der freien Kühlung auch in Kombination mit mindestens 2, vorzugsweise mindestens 3 Kühlkreisläufen, wie in Fig. 13a, angewendet werden.

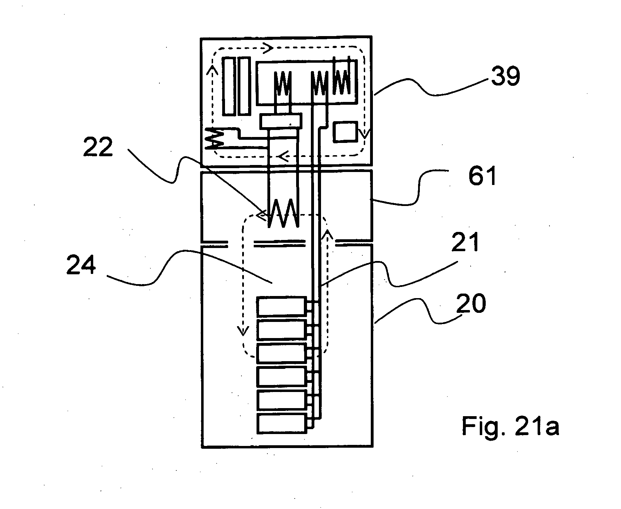

Bezug nehmend auf Fig. 21 soll erläutert werden, wie das Kühlmodul 39 mit einem Rack 20 verbunden ist. Das Kühlmodul 39 ist unmittelbar in Nähe des Racks 20 angeordnet oder in das Rack 20 integriert.

Über einen ersten Anschluss (43 in Fig. 20) wird ein erster Kühlkreislauf 21 versorgt, welcher der Prozessorkühlung dient. Dieser Kühlkreislauf ist nicht mit dem Kälteteil der in dem Kühlmodul 39 integrierten Kältemaschine verbunden.

Um die Luft innerhalb des Racks 20 zu kühlen, ist ein weiterer Kühlkreislauf 22 vorgesehen, welcher mit dem zweiten Anschluss des Kühlmoduls (44 in Fig. 20) verbunden ist.

Über diesen Wärmetauscher 24 wird die Luft innerhalb des Racks gekühlt. Der Kühlkreislauf 22 ist mit dem Kälteteil der in dem Kühlmodul 39 integrierten Kältemaschine (8 in Fig. 20) verbunden.

Durch die interne Kühlung des Racks kann das Rack nach außen thermisch neutral ausgeführt werden. Da auch das Kühlmodul thermisch nach außen neutral ist, wie in Fig.20 beschrieben, ist das Gesamtsystem, bestehend aus Rack und Kühlmodul nach außen thermisch neutral. Somit kann dieses System ohne zusätzliche Kühlung des umgebenden Raumes auskommen.

Fig. 21a zeigt ein Rack mit einem Kühlmodul 39 entsprechend Fig. 20, jedoch mit dem Unterschied, dass der Wärmetauscher und die Ventilatoren (nicht dargestellt) zur Kühlung des Racks mittels Wärmetauscher 22 als Rackkühlungsmodul 61 an das Rack angrenzend ausgebildet ist, und der Luftstrom zur Kühlung über Öffnungen des Racks 20 und des Rackkühlungsmodules 61 geführt wird. Das Rack 20, das Rackkühlungsmodul 61 und das Kühlmodul 39 können, wie hier dargestellt, angrenzend übereinander ausgeführt sein, als auch seitlich angrenzend (nicht dargestellt) oder in Kombination. Weiterhin kann das Kühlmodul 39 Bestandteil des Rackkühlmodules 61 sein, oder das Rackkühlungsmodul 61 kann Bestandteil des Kühlmodules 39 sein.

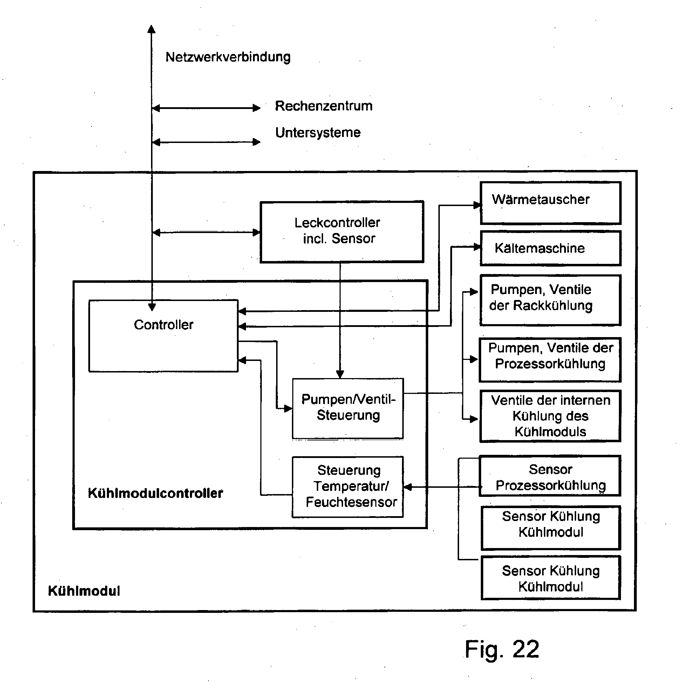

Bezugnehmend auf Fig. 22 soll die Steuerung eines Kühlmoduls näher erläutert werden. In Fig. 22 ist ein Modul dargestellt, welches eine Teilmenge der in Fig. 19 aufgeführten Komponenten beinhaltet.

Das Kühlmodul weist einen Controller auf, der insbesondere für die Steuerung der Pumpen und Ventile sowie die Steuerung von Temperatur und Feuchtigkeitssensoren zuständig ist. Über diesen Controller und die entsprechenden Pumpen und Ventile wird beispielsweise das Kühlmittel, welches zu einem Wärmetauscher oder zu einer Kältemaschine etc. läuft, gesteuert. Mithin ist der Controller beispielsweise über eine Netzwerkverbindung mit sämtlichen Komponenten, die über das Kühlmodul versorgt werden, verbunden.

Weiter ist der Controller mit einem Leck-Controller inklusive einem Feuchtigkeits- oder Drucksensor verbunden, über den ggf. die Pumpen und/oder die Spannung abgeschaltet werden kann.

Weiter ist das Kühlmodul über eine Netzwerkverbindung mit dem Rechensystem sowie mit den einzelnen Untersystemen, wie einzelnen Racks, Einrichtungen zur Spannungsversorgung und Telekommunikation verbunden.

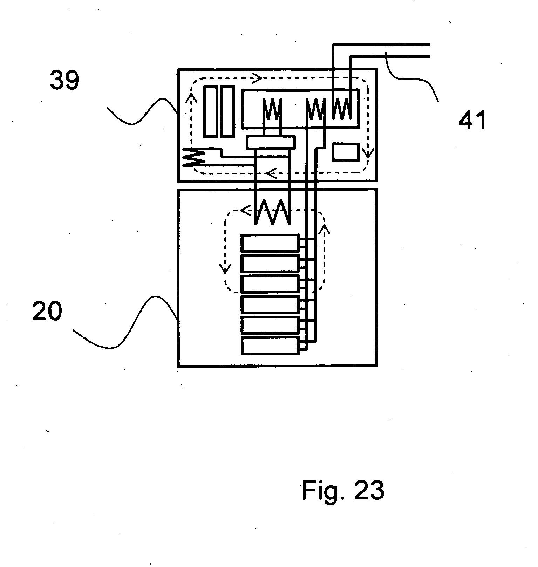

Bezugnehmend auf Fig. 23 soll weiterhin die Integration eines Kühlmoduls 39 in eine Rechenanlage näher erläutert werden.

Das Kühlmodul 39 ist in diesem Ausführungsbeispiel oberhalb des Servers 20 angebracht und entsprechend Fig. 21 mit dem Server 20 thermisch verbunden.

Das Kühlmodul 39 umfasst die Kältemaschine, einen Controller, Ventile, Pumpen und Sensoren, einen Wärmetauscher, über den die Wärme eines ersten Kühlkreislaufs und die Prozesswärme einer Kältemaschine zusammengeführt und über den Anschluss 41 abgeführt werden können.

Weiter umfasst das Kühlmodul eine Leck-Kontrolle und eine interne Kühlung.

Besonders von Vorteil ist, dass bei diesem modularen Aufbau lediglich die Prozesswärme über den Anschluss 41 nach außen abgeführt werden muss.

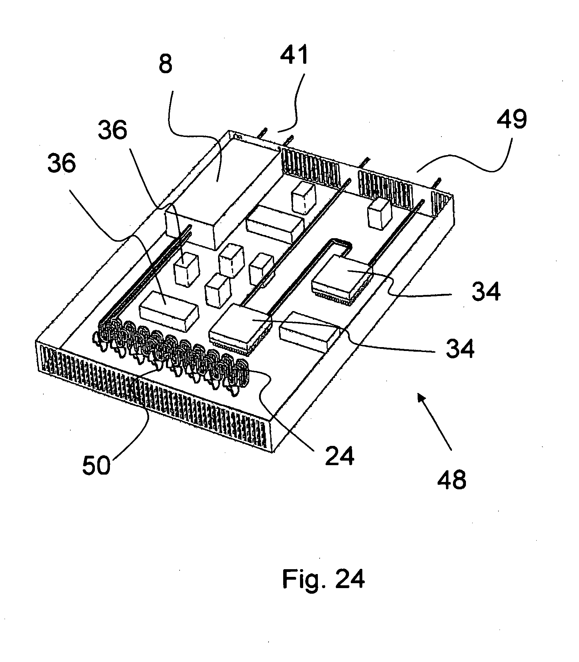

Bezugnehmen auf Fig. 24 soll ein in einem Server 48 integriertes System zur Kühlung einer Rechenanlage näher erläutert werden.

Das System umfasst eine in dem Gehäuse des Servers 48 integrierte Kältemaschine 8, insbesondere eine Kompressionskältemaschine.

Über den Kaltteil der Kompressionskältemaschine 8 wird kalte Flüssigkeit einem in dem Server angeordneten Wärmetauscher 24 zugeführt, über Lüfter 50 wird in dem Server 48 eine Luftströmung erzeugt und im Wärmetauscher 24 gekühlt. Die Temperatur kann in etwa auf Raumtemperatur gehalten werden. Weiterhin kann anstelle der Lüfter auch eine andere Form zur Erzeugung einer Fluidbewegung eingesetzt werden, beispielsweise basierend auf dem Prinzip der Elektro-Hydrodynamik (nicht dargestellt).

Über den Anschluss 41 (Vor- und Rücklauf) wird Prozesswärme der Kältemaschine 8 nach außen abgeführt.

Weiter ist eine erste Gruppe wärmeerzeugender Komponenten 34 über den Anschluss 49 (Vor- und Rücklauf) mit einer Prozessorkühlung gekoppelt. Über diese Prozessorkühlung wird ein großer Teil der Energie ohne Verwendung der Kältemaschine 8 abgeführt.

Eine weitere Gruppe wärmeerzeugender Komponenten 36 ist nicht mit einer Prozessorkühlung gekoppelt und wird über die kalte Luft im Gehäuse des Servers 48 gekühlt.

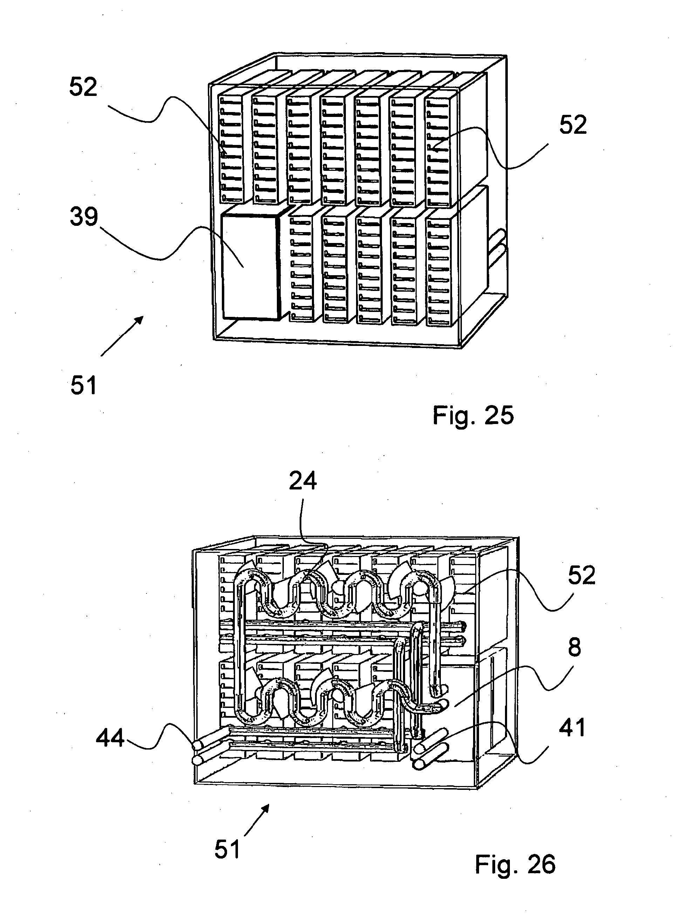

Bezug nehmend auf die Figuren Fig. 25 und Fig. 26 soll ein Ausführungsbeispiel erläutert werden, bei dem ein Kühlmodul in einem Blade-Server integriert ist.

Fig. 25 zeigt einen Blade-Server 51. Blade-Server sind auch unter der Bezeichnung Blade System oder Blade Center bekannt. Das Gehäuse des Blade-Servers weist eine Mehrzahl von Einschubplätzen für Module 52, sogenannte Blades, auf. Es kann sich dabei weiterhin beispielsweise um Festplatten, Speicherbausteine etc. handeln.

Das Kühlmodul 39 ist entsprechend der Modularität des Blade-Servers aufgebaut und wird ebenfalls eingesteckt. Es belegt in diesem Ausführungsbeispiel zwei Steckplätze des Blade-Servers.

Fig. 26 zeigt die Rückseite des Blade-Servers.

Über die Kühlmaschine 8 wird kaltes Kühlfluid bereitgestellt, welches einem internen Wärmetauscher 24 zugeführt wird, um das Gehäuseinnere des Blade-Servers 51 zu kühlen.

Prozesswärme der Kältemaschine kann über den Warmteil und den Anschluss 41 abgeführt werden.

Weiter sind die Module 52 mit einer Prozessorkühlung versehen.

Das Fluid der Prozessorkühlung braucht nicht über die Kältemaschine 8 geführt zu werden, sondern kann über den Anschluss 44 abgeführt werden. Es ist auch denkbar, das Fluid in Form der vorstehend beschriebenen sequentiellen Kühlung über den Warmteil der Kältemaschine 8 zu führen oder die Prozessorkühlung über einen zwischengeschalteten Wärmetauscher thermisch mit der Abführung der Prozesswärme zu koppeln.

So ist nur ein Anschluss zum Abführen von Prozesswärme nötig.

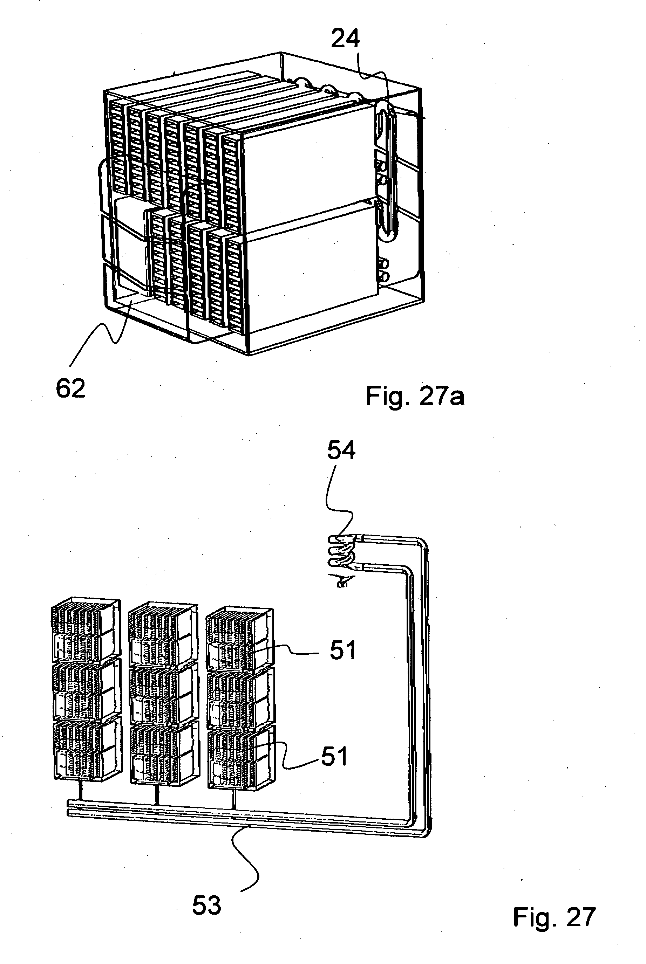

In Fig. 27 ist ein solches System mit mehreren Blade-Servern 51 dargestellt.

Die Blade-Server 51 umfassen lediglich einen Anschluss zum Abführen von Prozesswärme.

Ansonsten verfügen die Blade-Server, wie hier beispielhaft dargestellt, unter anderem beispielsweise über ein eingestecktes Kühlmodul, wie in Fig. 25 und Fig. 26 beschrieben, sowie über einen internen zweiten luftbasierten Kühlkreislauf, wie in Fig. 27a dargestellt. Es ist außerhalb des Servers lediglich ein Kühlkreislauf 53 vorgesehen, über den Wärme (Prozesswärme) über den Wärmetauscher 54 nach außen abgeführt wird.

In Fig. 27a ist ein zweiter luftbasierter Kühlkreislauf für Blade-Server dargestellt, bei welchem der Luftstrom 62 über den Wärmetauscher 24 geführt ist. Der Blade-Server ist so ausgeführt, dass dieser Luftstrom 62 innerhalb des Blade-Servers einen geschlossenen Luftkreislauf bildet, so dass der Blade-Server nach außen thermisch neutral ist oder sein kann (mit Ausnahme der flüssigkeitsbasierten Abführung der Prozesswärme).

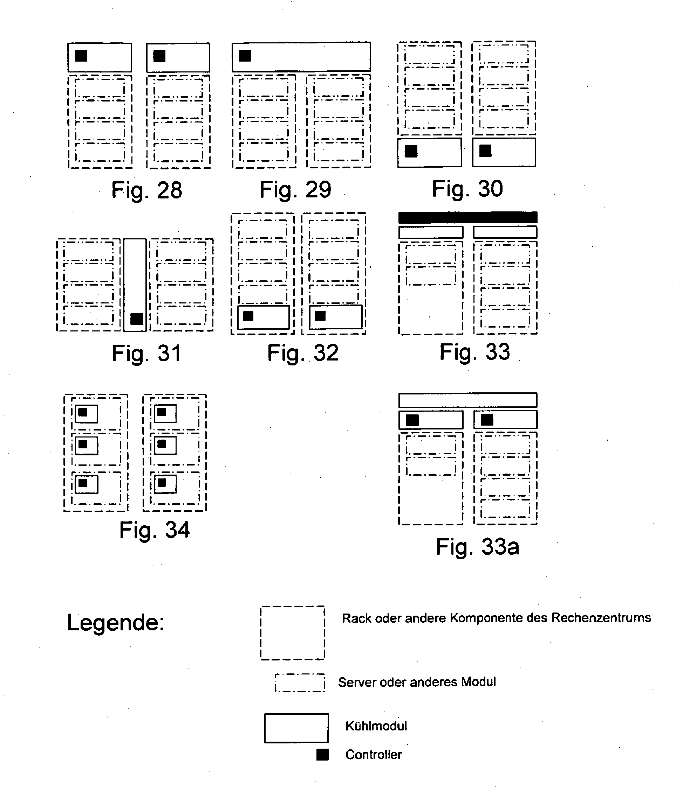

Bezugnehmend auf Fig. 28 bis Fig. 34 sollen die verschiedenen Möglichkeiten zur Integration bzw. Anordnung von Kühlmodul, Rechenanlage und Controller dargestellt werden.

Fig. 28 zeigt eine Ausführungsvariante, bei der jeweils ein Kühlmodul oben auf einem Rack angeordnet ist.

Fig. 29 zeigt eine Ausführungsvariante, bei der ein Kühlmodul oberhalb zweier Racks angeordnet ist, mithin für die Kühlung beider Racks verantwortlich ist.

Es versteht sich, dass statt zwei auch eine Mehrzahl weiterer Racks hinzutreten kann.

Fig. 30 zeigt die Anordnung jeweils eines Kühlmoduls unterhalb eines Racks.

Fig. 31 zeigt die Anordnung eines Kühlmoduls an der Seite eines Racks. Denkbar ist insbesondere, dass dieses Kühlmodul ein oder zwei Racks mit Kälte versorgt.

Fig. 32 zeigt eine Ausführungsform, bei der ein Kühlmodul beispielsweise als Einschub im Rack integriert ist.

Fig. 33 zeigt eine Ausführungsvariante, bei der der Controller des Kühlmoduls separat vom eigentlichen Kühlmodul angeordnet ist. Hierbei ist ein Controller für mehrere Kühlmodule zuständig. Diese Ausführungsform der Erfindung hat den Vorteil, dass die elektronische Kontrolleinrichtung nur einmal vorhanden sein muss.

Fig. 33a zeigt eine Ausführungsvariante ähnlich wie in Fig. 33 beschrieben, bei der aber die Komponenten von Kühlmodulen auf mehrere Kühlmodule verteilt sind. So ist es beispielsweise möglich, dass beispielsweise jedem Rack des Rechenzentrums je ein erstes Kühlmodul zugeordnet ist, welches beispielsweise je die Kältemaschine und weitere Komponenten des Kühlmodules zur Kühlung der Kühlkreisläufe des Racks enthält, während ein zweites Kühlmodul den Wärmetauscher der Rückkühlung der Prozesswärme enthält, und in diesem Wärmetauscher Kühlkreisläufe mehrerer Racks zusammenfasst.

Fig. 34 zeigt eine Konfiguration, bei der jeweils ein komplettes Kühlmodul mit Controller in einem Server oder einem anderen Modul des Racks integriert ist.

Wie der Legende zu entnehmen ist, wird unter einem Rack auch eine andere ähnliche Komponente des Rechensystems verstanden, beispielsweise eine Telekommunikationseinrichtung oder eine Spannungsversorgungseinrichtung.

Unter einem Server kann ebenfalls ein anderes Modul, wie ein Festplattenmodul etc., verstanden werden.

Weiterhin können auch Komponenten der Rechenanlage sowie Komponenten des Systems zur Kühlung einer Rechenanlage gemäß der Erfindung auch in einem Container untergebracht sein (nicht dargestellt).

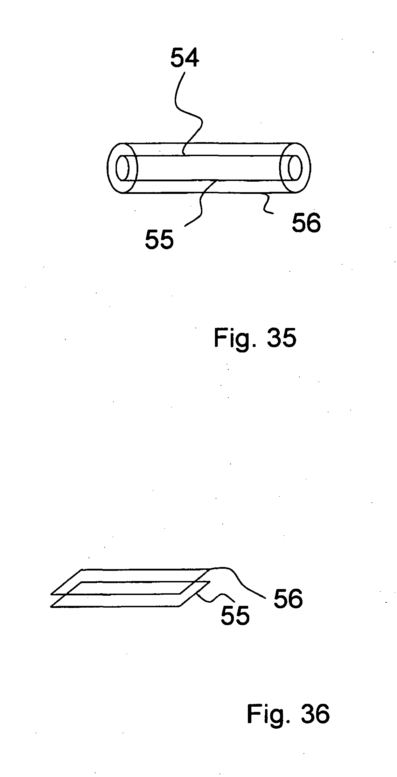

Bezugnehmend auf Fig. 35 soll eine weitere Möglichkeit der Leck-Detektion erläutert werden.

Gezeigt ist eine fluidführende Leitung 54.

Die fluidführende Leitung ist von zwei Elektroden 55, 56 umgeben. Dringt nun Wasser in den Bereich zwischen den Elektroden 55 und 56, ändert sich sowohl die Kapazität als auch die Leitfähigkeit zwischen den Elektroden.

Über einen entsprechenden Controller kann anhand der Leitfähigkeit und/oder anhand der Kapazität zwischen den Elektroden auf ein Leck geschlossen werden.

Ein ähnliches System kann, wie in Fig. 36 dargestellt ist, auch als Flächengebilde ausgebildet sein, bei welchem die Elektroden 55, 56 beispielsweise über ein wasserdurchlässiges Material von einander beabstandet sind.

So können die Elektroden beispielsweise als Teil der Gehäuseverkleidung verwendet werden oder am Boden eines Racks oder Servers platziert werden.

Über Leitfähigkeit und/oder Kapazität kann ebenfalls auf ein Leck geschlossen werden.

Bezug nehmend auf Fig. 37 soll eine Ausführungsform eines Modules zur Erkennung von Kühlmittelverlust (Leck-Erkennung) dargestellt werden.

Dieses Modul umfasst Mittel zur Erkennung eines Kühlmittelverlustes sowie Mittel zur Einleitung einer Notabschaltung.

Das System kann, wie hier dargestellt, auch einen eigenen Controller umfassen, der über Schnittstellen zur Kommunikation, zum Einlesen von Sensoren und zum Auslösen von unten beschriebenen Aktionen verfügt.

Die Erkennung eines Kühlmittelverlustes kann über eine Drücküberwachung des Kühlmittels erfolgen (beispielsweise in einem mit Überdruck arbeitenden Kühlsystem), weiterhin über Sensoren, welche Flüssigkeiten erkennen können (kapazitiv oder resistiv, siehe Fig. 35 und Fig. 36), oder über einen unerwarteten Temperaturanstieg in den zu kühlenden Komponenten der Rechenanlage (Temperaturüberwachung in oder an den zu kühlenden Bauteilen, beispielsweise Prozessoren), oder über infolge fehlenden zu pumpenden Mediums mit höherer Drehzahl laufender Kühlmittelpumpen, sowie mit Durchflussmessern, welche die Menge des durchströmenden Kühlmittels überwachen.

Ein Vorteil der Anwendung von Sensoren, welche unabhängig von der elektrischen Leitfähigkeit des Kühlmittels arbeiten (beispielsweise Drucksensoren), ist es, dass auch Kühlmittel mit geringerer Leitfähigkeit (beispielsweise < 2 * 10⁻⁸ S/m) eingesetzt werden können.

Vorzugsweise ist ein System aus mehreren Mitteln und Sensoren wie oben beschrieben in und nahe des Kühlmodules, der Server, Racks, anderer Komponenten des Rechenzentrums wie Stromversorgungen, und Verbindungsleitungen für die Kühlmittel verteilt. Im Falle eines Lecks kann so der Ort der Leckage bestimmt werden.

Die Mittel zur Einleitung einer Notabschaltung können eine Kommunikationsschnittstelle umfassen, über welche Komponenten des Rechenzentrums und/oder zuständiges Personal über einen Kühlmittelverlust informiert werden. Weiterhin können die Mittel zur Notabschaltung insbesondere eine Unterbrechung für die Stromversorgung der betreffenden Komponente (oder mehrerer Komponenten) des Rechenzentrums (z.B. für das Rack) sowie Schnittstellen zur Steuerung oder Abschaltung von Pumpen und Ventilen umfassen, mit der auf weiter unten beschriebene Weise die Notabschaltung durchgeführt werden kann.

Weiter kann über einen Leck-Controller und ein zugeordnetes Regelsystem bestimmt werden, welche Eingriffe (Abschaltung, teilweise Abschaltung, kontrollierte oder unmittelbare Abschaltung) ergriffen werden müssen, um das System zu schützen.

Hierzu ist der Leck-Controller mit einem Schalter für die Hauptstromversorgung für einen Server oder ein Rack verbunden. Weiter verfügt der Controller über eine Kommunikationsschnittstelle, um beispielsweise auf dem Rechensystem oder auf einem übergeordneten Steuerungs- und Überwachungssystem des Datencenters optisch und akustisch eine Leck-Meldung zu generieren und/oder um andere Module zu steuern, oder um eine kontrollierte Abschaltung zu koordinieren.

Weiter umfasst der Controller eine direkte Schnittstelle für die Steuerung von Pumpen und Ventilen.

Abhängig von der Größe, Ort und Schwere des Lecks kann beispielsweise ein System kontrolliert heruntergefahren werden oder im Falle eines Notfalls abrupt von der Stromversorgung getrennt und abgeschaltet werden.

Beispielsweise kann eine Situation entstehen, bei der zwar Kühlmittel austritt, aber noch keine unmittelbare Gefahr einer Beschädigung der Rechenanlage oder deren Komponenten besteht. In diesem Fall kann die Rechenanlage kontrolliert heruntergefahren und abgeschaltet werden, so dass die laufenden Anwendungen geschlossen werden und die Daten gesichert werden. Gegebenenfalls können die Anwendungen und/oder Daten auch auf andere, nicht von dem Kühlmittelverlust betroffene Rechenanlagen oder deren Komponenten verlagert werden. Bei dieser kontrollierten Abschaltung kann auch sichergestellt werden, dass eine Unterbrechung des Kühlmittelflusses nicht zu lokalen Überhitzungen in den am Kühlkreislauf angeschlossenen Komponenten führt.

Danach kann dem System zur Erkennung von Kühlmittelverlusten über die Kommunikationsschnittstelle der Befehl zur Notabschaltung gegeben werden.

Bei dieser Notabschaltung können beispielsweise die gesamte Rechenanlage oder Abschnitte der Rechenanlage spannungsfrei geschaltet werden und/oder die Pumpen zum Umwälzen des Kühlmittels abgeschaltet werden. So werden eventuelle Beschädigungen von Komponenten der Rechenanlage oder des Rechenzentrums durch Kühlwasser vermieden oder reduziert. Weiter ist denkbar, dass die Notabschaltung eine Pumpe umfasst, über die im Falle der Erkennung eines Flüssigkeitsverlustes ein Unterdruck im Kühlmittelsystem erzeugt wird. Beispielsweise kann die Pumpe die Flüssigkeit in ein dafür vorgesehenes Reservoir oder auch in die Kanalisation abpumpen. Aufgrund des entstehenden Unterdruckes tritt kein oder nur wenig weiteres Wasser aus, so dass der Schaden in der Anlage lokal begrenzt bleibt. Weiterhin können über Ventile die Kühlflüssigkeitsleitungen geschlossen werden, wobei auch verhindert werden kann, dass weitere Flüssigkeit aus der Anlage austreten kann.

Es kann auch eine Situation entstehen, in der eine unmittelbare Gefahr für Beschädigungen der Rechenanlage nicht auszuschließen ist. In diesem Fall kann unmittelbar die Abschaltung der Spannungsversorgung und der Pumpen erfolgen, ohne die Rechenanlage zuvor kontrolliert herunterzufahren, und ohne die laufenden Anwendungen zu Schließen und die Daten zu sichern.

Bei einer weiteren Ausführungsform der Erfindung sind Mittel zur Notabschaltung in einem Rack oder einer anderen Komponente der Rechenanlage integriert oder adaptiert.

Insbesondere im Fall dass die Kühlanlage als integriertes oder adaptiertes Modul ausgeführt ist, kann gegebenenfalls die Abschaltung des Kühlmodules und der Komponente des Rechenanlage oder des Rechenzentrums lokal erfolgen, ohne andere Komponenten der Rechenanlage oder des Rechenzentrums davon beeinflusst werden.

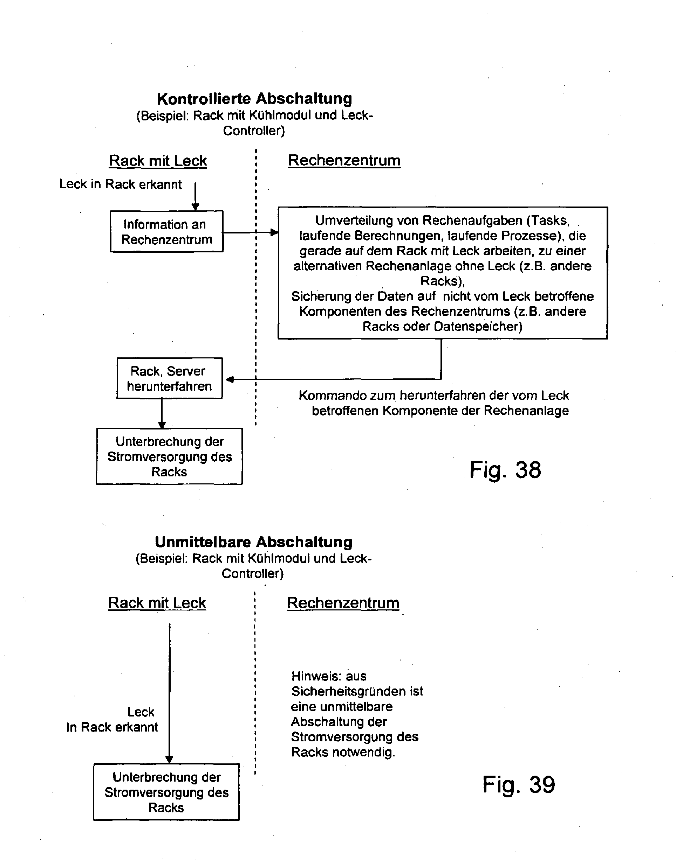

Das Prozedere des Herunterfahrens und der Abschaltung ist in dem Flussdiagrammen in Fig. 38 und Fig.39 wiedergegeben.

Fig.38 zeigt eine kontrollierte Abschaltung.

Sobald ein Leck in einem Rack detektiert wird, wird das Rechenzentrum über eine elektronische Schnittstelle informiert.

Innerhalb des Rechenzentrums werden dann Anwendungen, welche auf dem vom Leck betroffenen Bereich laufen, auf andere, nicht von der Leckage betroffene Teile des Systems verteilt. Weiterhin werden die Daten gesichert.

Sodann wird das betroffene System heruntergefahren und anschließend von der Stromversorgung getrennt.

Im Falle einer Notfallabschaltung, beispielsweise aufgrund eines größeren Wassereintritts, wird, wie in Fig. 39 dargestellt, die Stromversorgung für ein Rack sofort getrennt (unmittelbare Abschaltung). Da in diesem Beispiel auch das Kühlmodul, welches auch den Leck-Controller enthält, sofort mit abgeschaltet wird, erfolgt keine Benachrichtigung des Rechenzentrums über eine elektronische Schnittstelle.

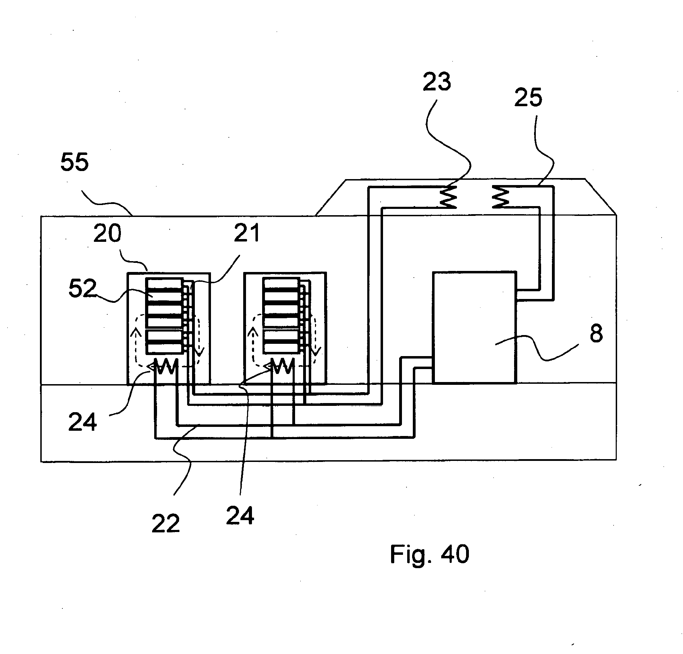

Fig. 40 zeigt ein schematisch dargestelltes Ausführungsbeispiel eines Rechenzentrums 55.

Das Rechenzentrum 55 umfasst eine Mehrzahl an Racks 20, welche ihrerseits einzelne Module 52, wie Server, Festplatteneinheiten etc. umfassen.

In dieser Ausführungsform sind die Module 52 über eine Flüssigkeitskühlung mit einem ersten Kühlkreislauf 21 verbunden, über den über den Wärmetauscher 23 Wärme nach außen abgeführt wird.

Ein zweiter Kühlkreislauf 22 mit geringerer Vorlauftemperatur, über den in einem internen Luftkreislauf die Komponenten des Racks gekühlt werden, wird über eine Kältemaschine 8 versorgt. Hierfür ist innerhalb der Racks 20 ein Wärmetauscher vorgesehen.

Bezüglich der einzelnen Racks ist sowohl der erste Kühlkreislauf 21 als auch der zweite Kühlkreislauf 22 zusammengeführt. Dies kann über den Anschluss der Wärmetauscher 24 am Kühlkreislauf 22 erfolgen, indem diese parallel am Kühlkreislauf 22 angeschlossen sind. Denkbar ist auch, dass die Wärmetauscher 24 hintereinander geschaltet sind, das Kühlfluid also von einem Wärmetauscher zum nächsten fließt (nicht dargestellt).

Über einen weiteren externen Wärmetauscher 25 wird vom Warmteil der Kältemaschine ausgehend Prozesswärme abgeführt.

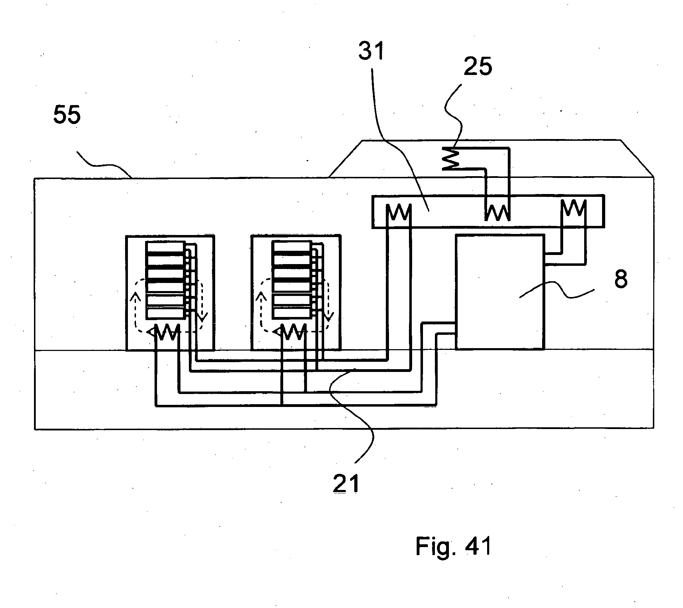

Fig. 41 zeigt ein weiteres Ausführungsbeispiels eines Rechenzentrums 55.

Soweit nicht anders beschrieben, entspricht das Rechenzentrum 55 dem in Fig. 40 dargestellten Ausführungsbeispiel.

Im Unterschied zu Fig. 40 ist der erste Kühlkreislauf 21 für die Prozessorkühlung über einen Wärmetauscher 31 thermisch mit dem Kühlkreislauf des Warmteils der Kältemaschine 8 verbunden.

Dies ist möglich, da die Kühlkreisläufe eine ähnliche Temperatur haben.

Diese Ausführungsform der Erfindung hat den Vorteil, dass somit nur noch ein Anschluss zum Abführen von Abwärme über den Wärmetauscher 25 vorhanden sein muss.

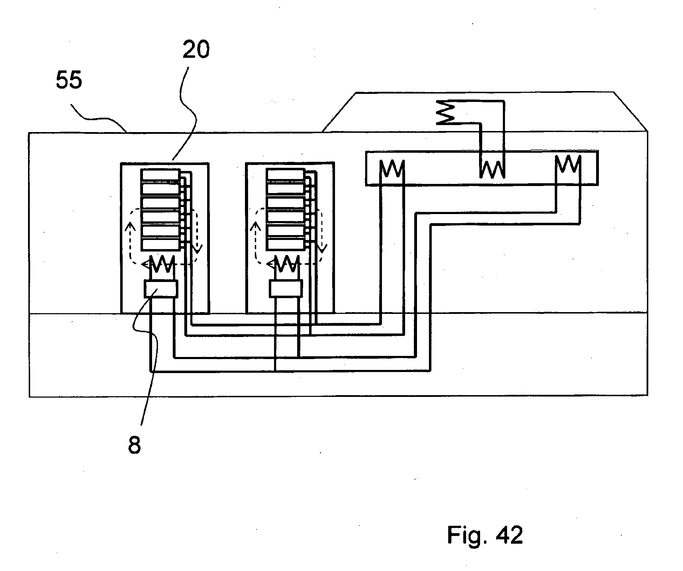

Fig. 42 zeigt ein weiteres Ausführungsbeispiel der Erfindung, welches auf Fig. 41 beruht.

Im Unterschied zu Fig. 41 ist jeweils für ein Rack 20 eine Kältemaschine vorgesehen.

Die Abwärmeteile der Kältemaschine sind zusammengeführt.

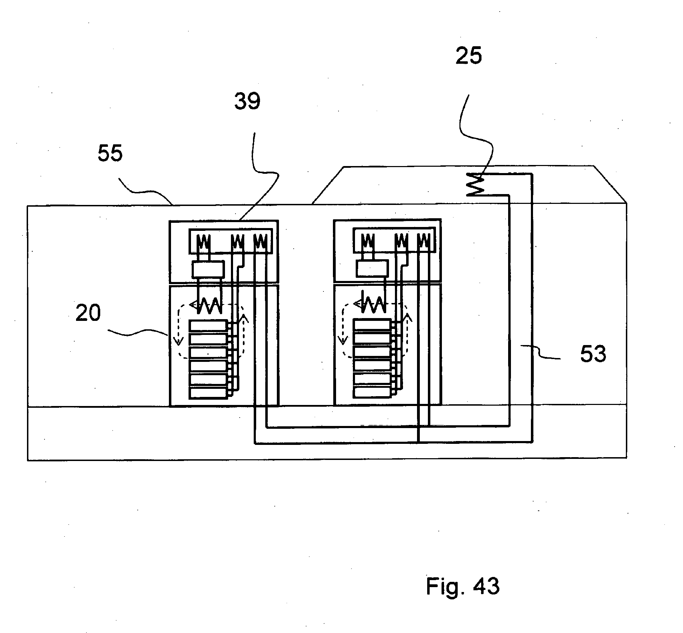

Fig. 43 zeigt ein weiteres Ausführungsbeispiel eines Rechenzentrums 55, bei welchem die Server 20 mit einem Kühlmodul 39 (wie zuvor dargestellt) verbunden sind.

Der Vorteil dieser Ausführungsvariante ist, dass, um dem System Energie zu entziehen, nur die Kühlmodule über den Kühlkreislauf 53 verbunden sein müssen, über den über den Wärmetauscher 25 Wärme nach außen abgeführt wird. Es versteht sich, dass diese Wärme auch als Nutzwärme verwendet werden kann.

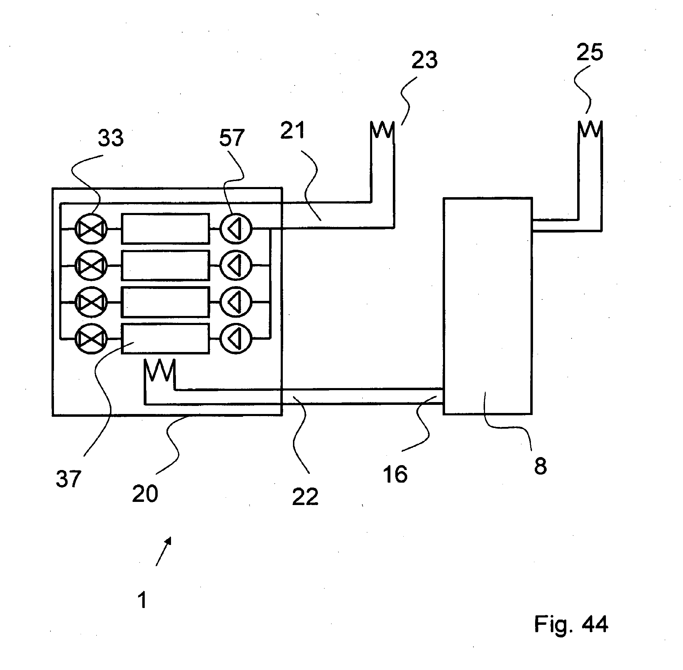

Fig. 44 zeigt eine Ausführungsform der Erfindung, bei welcher mehrere Server 37 in einem Rack 20 enthalten sind, und bei welcher ein Kühlkreislauf der Server 37, welcher beispielsweise eine Prozessorkühlung ist, über mehrere Server zu einem ersten Kühlkreislauf 21 zusammengefasst ist, wobei der Volumenstrom der Kühlflüssigkeit für jeden Server getrennt über eine Pumpe 57 und optional ein zusätzliches Ventil 33 gesteuert werden kann. Die Wärme wird über den Rückkühler 23 an die Umgebung abgegeben. Beispielsweise über Auswertung von Temperatursensoren (nicht dargestellt) können die Pumpen 57 und optional die Ventile 33 so angesteuert werden, wie der jeweilige Prozessorkühlkreislauf in den Servern benötigt. Damit kann der Volumenstrom des Kühlmittels in den jeweiligen Servern auf den jeweils erforderlichen Wert geregelt werden, es kann weiterhin die Pumpenleistung optimal an den erforderlichen Wert angepasst werden, und es kann die Temperaturdifferenz zwischen Einlass und Auslass der Prozessorkühlkreisläufe über den regelbaren oder einstellbaren Volumenstrom bei gegebener abzuführender Wärme geregelt werden.

Es versteht sich, dass diese Einstellung des Volumenstromes auch für mehrere Kühlkreisläufe anwendbar ist, beispielsweise, beispielsweise die in Fig. 13 beschriebenen Kühlkreisläufe 21,22 und 38.

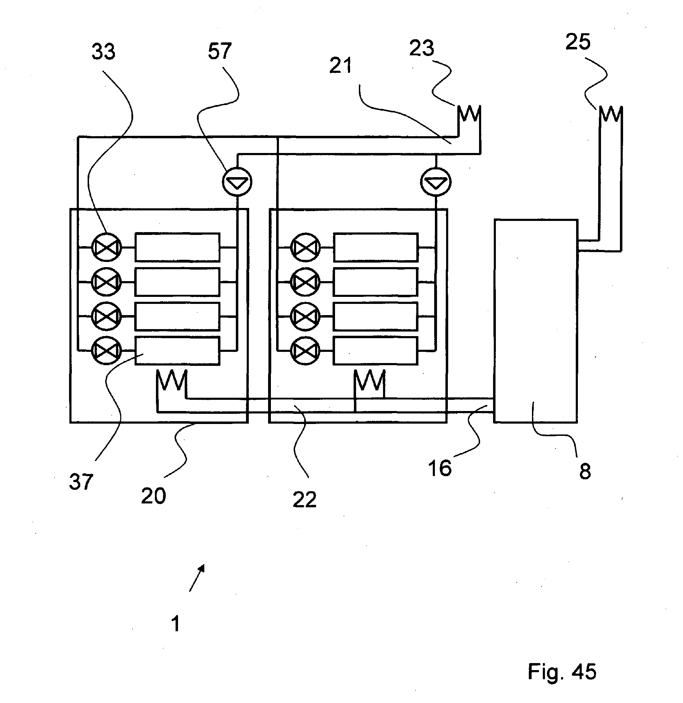

Fig. 45 zeigt eine Konfiguration, bei der mehrere Racks 20 vorhanden sind, und bei welchen ein Kühlkreislauf der Server 37, welcher beispielsweise eine Prozessorkühlung ist, über mehrere Server zu einem ersten Kühlkreislauf 21 zusammengefasst ist, wobei der Volumenstrom der Kühlflüssigkeit für jeden Server getrennt über ein Ventil 33 gesteuert werden kann, und wobei der Volumenstrom für jedes Rack über eine Pumpe gesteuert ist. Somit kann der Volumenstrom für jedes Rack 20 und für jeden Server 37 getrennt eingestellt und geregelt werden.

Es versteht sich, dass diese Einstellung des Volumenstromes auch für mehrere Kühlkreisläufe anwendbar ist, beispielsweise die in Fig. 13 beschriebenen Kühlkreisläufe 21,22 und 38.

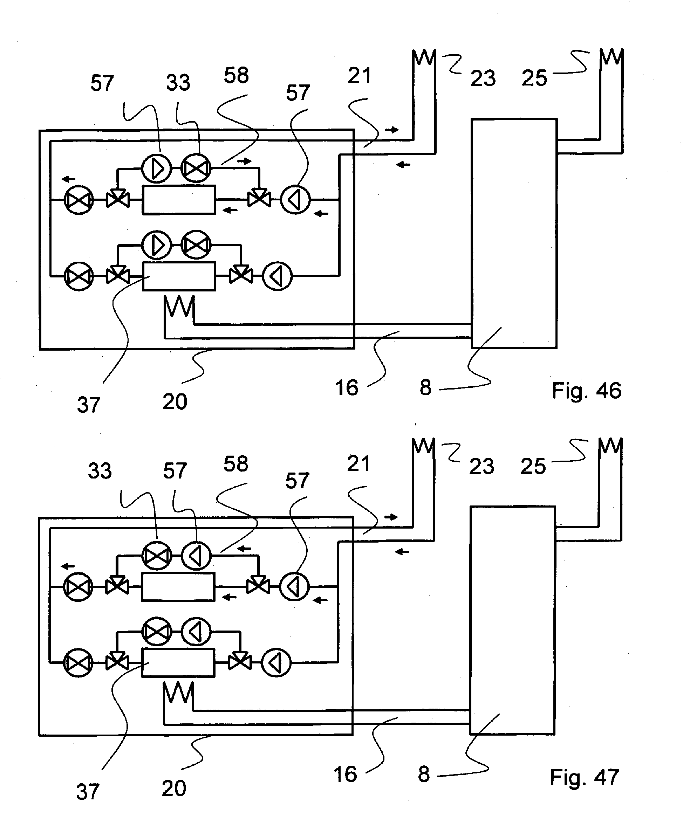

Fig. 46 zeigt eine weitere Ausführungsform der Erfindung, bei welcher ein Rack 20 mit einzelnen Modulen, dargestellt als Server 37 ausgestattet ist, und bei welcher ein Kühlkreislauf beispielsweise eine Prozessorkühlung ist. Abweichend von den bisher dargestellten Ausführungsformen ist für jeden Server ein Bypass 58 vorgesehen, über welchen über ein Ventil 33 oder eine T-förmige Verzweigung Kühlflüssigkeit am Server vorbei geleitet werden kann. Über einen regelbaren Bypass kann ein Teil des Kühlmittels, welches die Module durchströmt, in einem Kreislauf vom Kühlmittelausgang der Server 37 zum Kühlmitteleingang der Server 37 zurückgeführt werden, ohne über den Prozessorkühlungsanschluss 21 des Racks und den Wärmetauscher der Rückkühlung 23 geführt zu werden. Dadurch kann die den Server durchströmende Kühlmittelmenge erhöht werden und damit die Temperaturdifferenz zwischen Kühlmittelauslass und Kühlmitteleilass der Server verringert werden, ohne dass eine Erhöhung der Durchflussmenge des Wärmetauschers der Rückkühlung 23 notwendig ist. Der Bypass kann beispielsweise abhängig von der individuellen Serverbelastung und/oder von der individuellen Servertemperatur gesteuert werden, so dass der individuelle Server lastabhängig seine Temperaturen am Kühlmittelauslass und Kühlmitteleinlass beeinflussen kann. Dies kann im Zusammenhang mit optimaler Auslegung des Kühlsystemes eines individuellen Rechenzentrums (zum Beispiel Dimensionierung der Kühlmitteltemperaturen, Vermeidung geringer Temperaturen infolge großer Temperaturdifferenzen und damit Vermeidung von Kondensation, Dimensionierung von Volumenströmen) von Bedeutung sein.

Weiterhin kann durch den Bypass und der damit möglichen Erhöhung der die hier dargestellte Prozessorkühlung der Server durchströmende Kühlmittelmenge eine homogenere Temperaturverteilung über allen am Kreislauf der Prozessorkühlung angeschlossenen Bauteile erreicht werden.

In einem Betriebszustand, in welchem bei mehreren an die Prozessorkühlung eines Servers angeschlossenen Bauteilen beispielsweise nur ein Bauteil sehr viel abzuführende Wärmeenergie erzeugt, die anderen Bauteile jedoch sehr wenig, kann durch Erhöhung der Durchflussmenge des Kühlmittels im individuellen Server eine Überhitzung des Bauteiles verhindert werden, ohne den Volumenstrom des Kühlmittels des Gesamtsystems zu beeinflussen.

So kann sich das System wechselnden Rechenbelastungen oder Betriebsbedingungen auch über die Steuerung der Kühlflüssigkeit im Bypass anpassen.

Der Bypass und die Menge der den Bypass durchströmenden Kühlflüssigkeit kann über regelbare Ventile und ansteuerbare Pumpen, eingestellt werden. Die Steuerung (nicht dargestellt) kann über den Server oder außerhalb des Servers erfolgen, wobei auch Temperatursensoren (nicht dargestellt) mit einbezogen werden können.

Ein Bypass kann auch über ein gesamtes Rack, beispielsweise über die Wärmetauscher 24 des zweiten Kühlkreislaufes 22, oder eine andere Anlage des Rechenzentrums (beispielsweise eine Stromversorgung) gelegt werden anstelle über einzelne Server (nicht dargestellt). Die Wirkungsweise entspricht der des Bypasses über einen Server.

Es versteht sich, dass der Bypass auch für mehrere Kühlkreisläufe anwendbar ist, beispielsweise die in Fig. 13 beschriebenen Kühlkreisläufe 21, 22 und 38.

Fig. 47 zeigt eine weitere Ausführungsform des Kühlsystems mit einem Bypass, ähnlich wie beschrieben in Fig. 46, jedoch mit dem Unterschied, dass die Kühlflüssigkeit nicht vom Auslass der Prozessorkühlung des Servers 37 in den Einlass der Prozessorkühlung des Servers 37 zurückgeführt wird, sondern dass Kühlflüssigkeit am Server vorbeigeführt wird. Damit lässt sich der Volumenstrom im Kühlmittelkreislauf der Prozessorkühlung verringern, ohne den Volumenstrom im Wärmetauscher der Rückkühlung 23 zu beeinflussen. Ein weiterer Vorteil dieses Bypasses liegt in der möglichen Reduzierung des Druckverlustes bei Servern mit geringer Last.

Ein Kühlsystem kann im Sinne der Erfindung aus einer Anzahl von Kühlkreisläufen bestehen, die auch in verschiedener Weise zusammengeschaltet werden können. Wie beispielsweise in Fig. 9 und in Fig. 13a dargestellt ist, können diese Kühlkreisläufe zu einem Kreislauf verbunden werden, in dem die verschiedenen Kühlkreisläufe reihenweise hintereinandergeschaltet werden, wobei die einzelnen der hintereinander geschalteten Kühlkreisläufe ein anderes Temperaturniveau haben (sofern jeder der einzelnen Kreisläufe eine thermische Energie aufnimmt), aber der Volumenstrom in allen hintereinander geschalteten Kühlkreisläufen identisch ist. Jeder Kühlkreislauf ist von einem Druckverlust betroffen, welcher sich bei hintereinandergeschalteten Kühlkreisläufen addiert, und welcher durch die Pumpen des Kühlkreislaufes kompensiert werden muss. Wenn ein Modul (beispielsweise ein Server)des Kühlkreislaufes, oder auch mehrere Module (beispielsweise Server) weniger belastet werden, und weniger thermische Energie abgeführt werden muss, ist es durch den beschriebenen Bypass möglich, den Volumenstrom des Kühlmittels individuell im weniger belasteten Server zu reduzieren, ohne damit den Volumenstrom in anderen hintereinandergeschalteten Servern zu reduzieren. Weil ein Bypass in der Regel einen deutlich geringeren Druckverlust aufweist als der Kühlkreislauf in einem Modul (damit begründet, dass der Bypass über kurze Leitungslängen für das Kühlmittel geführt wird, während in einem Modul, beispielsweise in einem Server, der Kühlkreislauf über längere Leitungslängen über beispielsweise mehrere Prozessoren oder andere Leistungsbauteile geführt wird), sinkt damit auch der durch die Pumpen zu kompensierende Druckverlust, und damit die benötigte Pumpenleistung. Somit kann durch den beschriebenen Bypass je nach Auslegung und Konfiguration des Kühlsystemes die benötigte Pumpenleistung an die individuelle zu kühlende thermische Last in den einzelnen durch Kühlkreisläufe gekühlten Modulen, beispielsweise Servern, angepasst werden.

Ein Bypass kann auch über ein gesamtes Rack, beispielsweise über die Wärmetauscher 24 des zweiten Kühlkreislaufes 22, oder eine andere Anlage des Rechenzentrums (beispielsweise eine Stromversorgung) gelegt werden anstelle über einzelne Server (nicht dargestellt). Die Wirkungsweise entspricht der des Bypasses über einen Server.

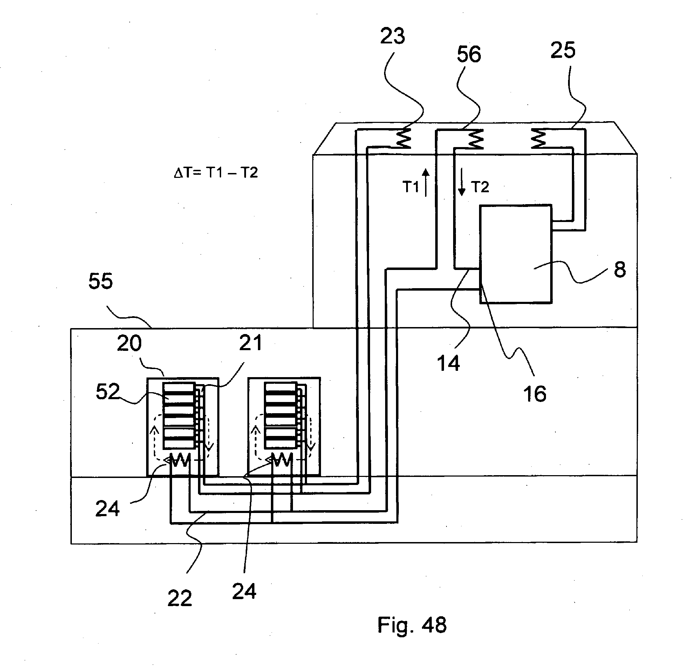

Fig. 48 zeigt ein weiteres Ausführungsbeispiel der Erfindung, welches auf Fig. 40 beruht. Im Unterschied zu Fig. 40 ist zum einen beispielhaft dargestellt, dass die Kältemaschine nicht im Rechenzentrum angeordnet ist, sondern außerhalb, hier dargestellt angrenzend an die Wärmetauscher 23, 25 und 56.

Als weiterer Unterschied zu Fig. 40 ist eine freie Kühlung dargestellt, wobei das Kühlfluid des zweiten Kühlkreislaufes 22 zunächst durch den Wärmetauscher für freie Kühlung 56 geleitet wird, bevor es zum Einlass 14 des Kälteteiles 16 der Kältemaschine 8 geleitet wird. Dabei wird das Kühlfluid, abhängig unter anderem von den Umgebungsbedingungen (z.B. Temperatur) an dem Wärmetauscher 56, um einen Betrag ΔT abgekühlt, womit die von der Kältemaschine 8 zu erbringende Kälteleistung und folglich deren Energieverbrauch reduziert wird. Je nach Umgebungsbedingungen für den Wärmetauscher 56 kann ggf. auch die vollständige Kühlleistung für den zweiten Kühlkreislauf 22 durch die freie Kühlung bereitgestellt werden, beispielsweise bei geringen Umgebungstemperaturen von beispielsweise kleiner 10 °C.

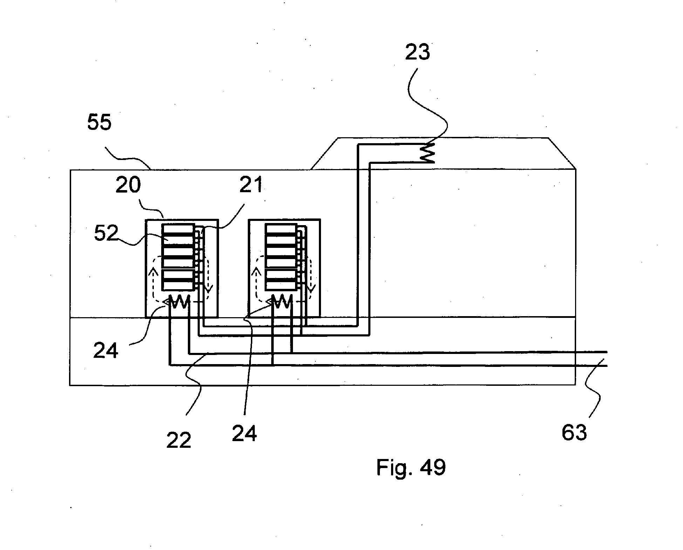

Fig. 49 zeigt ein weiteres Ausführungsbeispiel der Erfindung, welches auf Fig. 40 beruht. Im Unterschied zu Fig. 40 wird hier der zweite Kühlkreislauf an einen Kaltwasseranschluss 63 angeschlossen, welcher dem Rechenzentrum zur Verfügung gestellt ist. Dieser Kaltwasseranschluss kann beispielsweise durch eine nicht im Rechenzentrum befindliche Kältemaschine mit Kälteenergie versorgt werden, oder durch einen gewöhnlichen Anschluss der Wasserversorgung oder durch eine geothermale Kühlanlage.

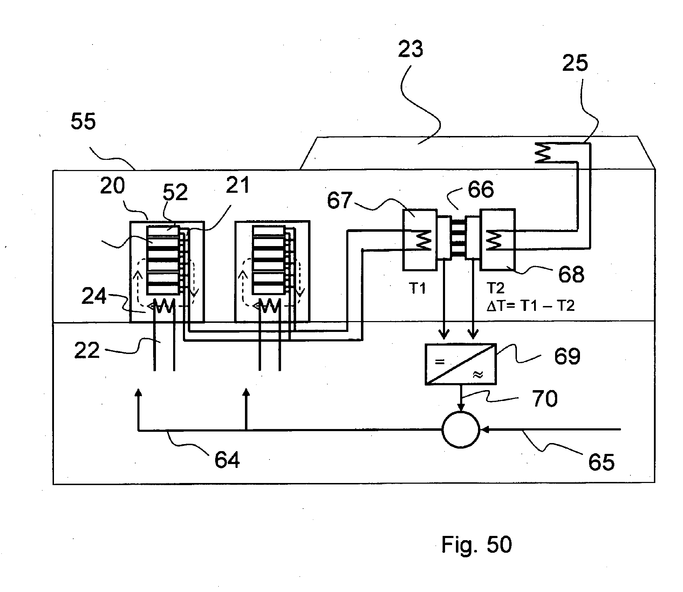

Fig. 50 zeigt ein schematisch dargestelltes weiteres Ausführungsbeispiel eines Rechenzentrums 55, welches eine Rückgewinnung von Elektroenergie aus thermischer Energie umfasst.

Das Rechenzentrum 55 umfasst eine Mehrzahl an Racks 20, welche ihrerseits einzelne Module 52, wie Server, Festplatteneinheiten etc. umfassen.

In dieser Ausführungsform sind die Module 52 über eine Flüssigkeitskühlung mit einem ersten Kühlkreislauf 21 verbunden.

Ein zweiter Kühlkreislauf 22 mit geringerer Vorlauftemperatur, über den in einem internen Luftkreislauf die Komponenten des Racks gekühlt werden, wird über eine Kältemaschine 8 versorgt. Hierfür ist innerhalb der Racks 20 ein Wärmetauscher vorgesehen. Dieser Kühlkreislauf ist hier nur angedeutet, die Kühlung selbst ist nicht dargestellt.

Bezüglich der einzelnen Racks ist zumindest der erste Kühlkreislauf 21 zusammengeführt.

Das Ausführungsbeispiel beinhaltet einen thermoelektrischen Generator, oder ein Peltierelement 66. Der erste Kühlkreislauf mit einer Vorlauftemperatur T1 ist zunächst mit einem Wärmetauscher (Warmseite) für ein Element zur Elektroenergie-Gewinnung 67 geführt, welcher thermisch mit einer Seite des thermoelektrischen Generators 66 verbunden ist. Ein weiterer Wärmetauscher (Kaltseite) für ein Element zur Elektroenergie-Gewinnung 68 ist thermisch mit der anderen Seite des thermoelektrischen Generators 66 verbunden, die Rücklauftemperatur an diesem Wärmetauscher (Kaltseite) 68 beträgt T2. Der Wärmetauscher (Kaltseite) 68 ist thermisch über einen Kühlkreislauf mit dem Wärmetauscher 25 der Rückkühlung verbunden.

Somit liegt an dem thermoelektrischen Generator 66 eine Temperaturdifferenz von ΔT = T1 - T2 an. Dadurch wird elektrische Energie erzeugt, welche in diesem Ausführungsbeispiel über einen Wechselrichter 69 als rückgeführte Energie 70 in die Stromversorgung eingespeist wird, so dass sich die benötigte Elektroenergie zur Versorgung des Rechenzentrums 65 um die rückgeführte Energie 70 vermindert, bei annährend gleichbleibender bereitgestellter Energiemenge zur Versorgung der Komponenten des Rechenzentrums 64.

Es kann somit thermische Energie in elektrische Energie umgewandelt werden, welche dem Rechenzentrum zugeführt wird, womit die Menge an Elektroenergie zur Versorgung eines Rechenzentrums vermindert wird.

Weiterhin wird die durch den Wärmetauscher 25 des Rückkühlers abzuführende thermische Energiemenge verringert, was zu verringerten Betriebskosten des Rückkühlers führt.

Es versteht sich, dass auch weitere physikalische Effekte zur Erzeugung von Elektroenergie aus thermischer Energie beziehungsweise einer Temperaturdifferenz ΔT genutzt werden können, beispielsweise kann anstelle des thermoelektrischen Generators 66 ein auf dem Carnot-Prozess beruhender mechanischer Generator, beispielsweise eine ORC (organic rankine cycle) Maschine, verwendet werden, welcher einen elektrischen Generator zur Energiegewinnung antreibt. Auch kann ein Stirling-Motor verwendet werden. Weiterhin kann ein thermomagnetischer Generator eingesetzt werden.

Weil bei einigen physikalische Prozessen zur Umwandlung thermischer Energie in eine andere Energieform der Wirkungsgrad proportional ist zur bereitgestellten Temperaturdifferenz ΔT (beispielsweise beim Carnot-Prozess), wird durch das erfindungsgemäße System zur Kühlung einer Rechenanlage, welches einen ersten Kühlkreislauf mit hoher Temperatur bereitstellt, die Umwandlung von thermischer Energie eines Rechenzentrums in elektrische Energie ermöglicht oder zumindest besser unterstützt.

Durch die Erfindung kann der zur Kühlung einer Rechenanlage erforderliche Energieverbrauch erheblich herabgesetzt werden.

### Bezugszeichenliste

- 1: System zur Kühlung einer Rechenanlage
- 2: Vorlauf erster Kühlkreislauf
- 3: Rücklauf erster Kühlkreislauf
- 4: Einlass zweiter Kühlkreislauf
- 5: Auslass zweiter Kühlkreislauf
- 6: Flüssigkeitsgekühlte Komponenten
- 7: Luftgekühlte Komponenten
- 8: Kältemaschine
- 9: Verdampfer
- 10: Kompressor
- 11: Kondensator
- 12: Expansionsventil
- 13: Kühlmittelkreislauf der Kompressormaschine
- 14: Einlass
- 15: Auslass
- 16: Kaltteil
- 17: Einlass
- 18: Auslass
- 19: Warmteil
- 20: Rack
- 21: Erster Kühlkreislauf
- 22: Zweiter Kühlkreislauf
- 23: Wärmetauscher (Rückkühlung)
- 24: Wärmetauscher (Rackkühlung)
- 25: Wärmetauscher (Rückkühlung)
- 26: Modul
- 27: Lüfter
- 28: Anschluss
- 29: Anschluss
- 30: Rechenanlage
- 31: Wärmetauscher
- 32: Kühlkreislauf Warmteil
- 33: Ventil
- 34: Erste Gruppe wärmeerzeugender Komponenten
- 35: Zweite Gruppe wärmeerzeugender Komponenten
- 36: Dritte Gruppe wärmeerzeugender Komponenten
- 37: Server
- 38: Dritter Kühlkreislauf
- 39: Kühlmodul
- 40: Controller
- 41: Anschluss (Rückkühlung)
- 42: Leckage Detektion
- 43: Anschluss Prozessorkühlung
- 44: Anschluss Rackkühlung
- 45: Gehäuse
- 46: Wärmetauscher
- 47: Luftzirkulation
- 48: Server
- 49: Anschluss
- 50: Lüfter
- 51: Blade-Server
- 52: Modul
- 53: Kühlkreislauf
- 54: Leitung
- 55: Rechenzentrum
- 56: Wärmetauscher (für freie Kühlung)
- 57: Pumpe
- 58: Bypass
- 59: Wärmetauscher der Kältemaschine
- 60: Kühlmittelanschlüsse
- 61: Rackkühlungsmodul
- 62: Luftstrom des Blade-Servers
- 63: Kaltwasseranschluss
- 64: Elektroenergie zur Versorgung von Komponenten des Rechenzentrums
- 65: Elektroenergie zur Versorgung des Rechenzentrums
- 66: Thermoelektrischer Generator, Peltierelement
- 67: Wärmetauscher für ein Element zur Elektroenergie-Gewinnung, Warmseite
- 68: Wärmetauscher für ein Element zur Elektroenergie-Gewinnung, Kaltseite
- 69: Wechselrichter
- 70: Rückgeführte Elektroenergie

## Patentansprüche

1. System zur Kühlung einer Rechenanlage (1),
umfassend eine Kältemaschine (8), die der Erzeugung von Kälte dient, also einer Temperatur, die geringer ist als die Umgebungstemperatur,
wobei die Rechenanlage einen ersten Kühlkreislauf (21) umfasst mit welchem in einem Gehäuse angeordnete Prozessoren und/oder Leistungsbauteile der Rechenanlage (1) mit einer Flüssigkeit kühlbar sind,
wobei der erste Kühlkreislauf mit einem Wärmetauscher (23) verbunden ist, wobei mittels des ersten Kühlkreislaufs (21) Wärme nach außen abgeführt oder als Nutzwärme für Heizung und Warmwasser weiter verwendet wird,
und wobei die Rechenanlage (1) einen zweiten Kühlkreislauf (22) umfasst, welcher mit einem Kaltteil der Kältemaschine (8) verbunden ist und welcher einen in dem Gehäuse angeordneten Wärmetauscher (24) umfasst, welcher an den zweiten Kühlkreislauf (22) angeschlossen ist und mit dem Luft in dem Gehäuse gekühlt wird, und wobei der zweite Kühlkreislauf (22) mit geringerer Vorlauftemperatur als der erste Kühlkreislauf (21) betrieben wird.

2. System zur Kühlung einer Rechenanlage nach dem vorstehenden Anspruch, **dadurch gekennzeichnet, dass** das System zumindest drei Kühlkreisläufe (21, 22, 38) umfasst, von denen ein Kühlkreislauf mittels Luft betrieben wird und die beiden weiteren Kühlkreisläufe mittels einer Flüssigkeit betrieben werden, wobei von den weiteren Kühlkreisläufen zumindest ein Kühlkreislauf sowohl mit einem externen Wärmetauscher (23) als auch mit einem Kaltteil der Kältemaschine (8) verbindbar ist.

3. System zur Kühlung einer Kältemaschine nach einem der vorstehenden Ansprüche, **dadurch gekennzeichnet, dass** der erste Kühlkreislauf (21) sowie der warmteil der Kältemaschine (8) jeweils einen Wärmetauscher umfassen welche über einen weiteren Wärmetauscher thermisch verbunden sind und Abwärme beider Kühlkreisläufe gemeinsam abführbar ist.

4. System zur Kühlung einer Rechenanlage nach einem der vorstehenden Ansprüche, **dadurch gekennzeichnet, dass** es sich bei der Kältemaschine (8) um eine Kompressionskältemaschine oder eine Sorptionskältemaschine, insbesondere eine Adsorptions-, Absorptions- und/oder eine auf dem Prinzip der absorptiven Trocknung (DCS), eine auf dem thermoelektrischen Effekt arbeitende Kältemaschine und/oder eine auf dem magnetokalorischen Prinzip arbeitende Kältemaschine und/oder eine geothermische Kältemaschine und/oder eine mit Peltier-Elementen arbeitende Kältemaschine und/oder eine Dampfstrahl-Kältemaschine und/oder eine nach dem Joule-Thomson-Effekt arbeitende Kältemaschine und/oder eine auf dem Prinzip der Verdunstungskühlung arbeitende Kältemaschine handelt.

5. System zur Kühlung einer Rechenanlage nach einem der vorstehenden Ansprüche, **dadurch gekennzeichnet, dass** das System Mittel zur variablen Verteilung des Kühlfluids innerhalb der Rechenanlage aufweist.

6. System zur Kühlung einer Rechenanlage nach einem der vorstehenden Ansprüche, **dadurch gekennzeichnet, dass** das System eine Regelungselektronik mit einer Schnittstelle zur Anbindung der Rechenanlage umfasst.

7. System zur Kühlung einer Rechenanlage nach einem der vorstehenden Ansprüche, **dadurch gekennzeichnet, dass** das System ein Kühlmodul (26) umfasst, in welchem zumindest die Kältemaschine (8) und eine elektronische Steuerung angeordnet ist.

8. System zur Kühlung einer Rechenanlage nach dem vorstehenden Anspruch, **dadurch gekennzeichnet, dass** die Vorlauftemperatur des ersten Kühlkreislaufs (21) sich um mindestens 20 °C, vorzugsweise zumindest 30 °C von der Vorlauftemperatur des zweiten Kühlkreislaufs (22) unterscheidet.

9. System zur Kühlung einer Rechenanlage nach einem der vorstehenden Ansprüche, **dadurch gekennzeichnet, dass** ein Wärmetauscher des ersten Kühlkreislaufs und/oder ein mit einem Warmteil der Kältemaschine verbundener Wärmetauscher mit dem Heizsystem eines Gebäudes, einer Warmwasserversorgung und/oder einem Stromerzeuger verbunden ist.

10. System zur Kühlung einer Rechenanlage nach einem der vorstehenden Ansprüche, **dadurch gekennzeichnet, dass** die Kältemaschine in ein Rack (20) und/oder in einen Server, insbesondere einen Blade-Server und/oder andere Komponenten (Stromversorgungen, Telekommunikation) integriert ist oder unmittelbar an einen Server oder an ein Rack angrenzt.

11. System zur Kühlung einer Rechenanlage nach einem der vorstehenden Ansprüche, wobei eine Flüssigkeit des zweiten Kühlkreislaufs nach Durchlaufen eines Kaltteils der Kältemaschine (8) über einen Wärmetauscher zur Kühlung der in der Rechenanlage vorhandenen Luft führbar ist, und wobei die Flüssigkeit nach Durchlaufen des Wärmetauschers dem ersten Kühlkreislauf zuführbar ist.

12. System zur Kühlung einer Rechenanlage nach einem der vorstehenden Ansprüche, **dadurch gekennzeichnet, dass** die Rechenanlage und die Kältemaschine (8) in einem Raum anordnet ist, insbesondere die Kältemaschine (8) in einer Komponente der Rechenanlage integriert ist oder an eine Komponente der Rechenanlage angrenzt, und wobei keine Klimaanlage zum Abkühlen der Raumluft vorhanden ist.

13. System zu Kühlung einer Rechenanlage nach einem der vorstehenden Ansprüche, **dadurch gekennzeichnet, dass** das System Mittel zur Notabschaltung im Falle eines Kühlmittelverlusts aufweist.

14. Verfahren zur Kühlung einer Rechenanlage, wobei die Rechenanlage zumindest einen ersten Kühlkreislauf (21) und einen zweiten Kühlkreislauf (22) umfasst, wobei der erste Kühlkreislauf (21) mit höherer Temperatur als der zweite Kühlkreislauf (22) und mittels einer Flüssigkeit betrieben wird, und wobei mittels des ersten Kühlkreislaufs (21) Wärme nach außen abgeführt oder als Nutzwärme für Heizung und Warmwasser weiter verwendet wird,
wobei zumindest der zweite Kühlkreislauf (22) über ein Kaltteil einer Kältemaschine (8), die der Erzeugung von Kälte dient, also einer Temperatur, die geringer ist als die Umgebungstemperatur, betrieben wird, wobei über den ersten Kühlkreislauf in einem Gehäuse angeordnete Prozessoren und/oder Leistungsbauteile mittels der Flüssigkeit gekühlt werden,
und wobei die Luft in dem Gehäuse über einen im oder am Gehäuse angeordneten Wärmetauscher (24), welcher an den zweiten Kühlkreislauf (22) angeschlossen ist, gekühlt wird.

15. Verfahren zur Kühlung einer Rechenanlage nach dem vorstehenden Anspruch, **dadurch gekennzeichnet, dass** ein Rücklauf des ersten Kühlkreislaufs (3) zeitweise sowohl mit einem Wärmetauscher als auch mit dem Kaltteil der Kältemaschine (8) verbunden wird, insbesondere mittels eines Wegeventils.

## Claims

1. A system for cooling a computing system (1), comprising a refrigeration machine (8) which is used to produce cold, that means a temperature that is lower than the ambient temperature;
wherein the computing system comprises a first cooling circuit (21) which can be used for cooling processors and/or power components of the computing system (1), which are arranged in a housing, using a liquid; wherein the first cooling circuit is connected to a heat exchanger (23), wherein by means of the first cooling circuit (21) heat is discharged to the outside or is reused as useful heat for heating purposes and hot water;
and wherein the computing system (1) comprises a second cooling circuit (22) which is connected to a cold section of the refrigeration machine (8) and which comprises a heat exchanger (24) arranged in the housing and connected to the second cooling circuit (22), which is used to cool air in the housing;
and wherein the second cooling circuit (22) is operated at a lower feed flow temperature than the first cooling circuit (21).

2. The system for cooling a computing system as claimed in the preceding claim, **characterized in that** the system comprises at least three cooling circuits (21, 22, 38), one cooling circuit of which is operated by air and the two other cooling circuits are operated using a liquid, wherein at least one cooling circuit of the other cooling circuits is connectable to both an external heat exchanger (23) and a cold section of the refrigeration machine (8).

3. The system for cooling a computing system as claimed in any of the preceding claims, **characterized in that** the first cooling circuit (21) and the hot section of the refrigeration machine (8) each include a heat exchanger, which heat exchangers are in thermal communication with each other through a further heat exchanger, and that waste heat from the two cooling circuits is dischargeable collectively.

4. The system for cooling a computing system as claimed in any of the preceding claims, **characterized in that** the refrigeration machine (8) is a compression-type refrigeration machine or a sorption refrigeration machine, in particular an adsorption refrigeration machine, absorption refrigeration machine and/or a refrigeration machine operating on the principle of absorptive dehumidification (DCS - Desiccant Cooling System), a refrigeration machine operating on the thermoelectric effect, and/or a refrigeration machine operating on the magnetocaloric principle, and/or a geothermal refrigeration machine, and/or a refrigeration machine operating with Peltier elements, and/or a steam jet refrigeration machine, and/or a refrigeration machine operating on the Joule-Thomson effect, and/or a refrigeration machine operating on the principle of evaporative cooling.

5. The system for cooling a computing system as claimed in any of the preceding claims, **characterized in that** the system includes means for selectively distributing the cooling fluid within the computing system.

6. The system for cooling a computing system as claimed in any of the preceding claims, **characterized in that** the system comprises control electronics including an interface for connecting the computing system.

7. The system for cooling a computing system as claimed in any of the preceding claims, **characterized in that** the system comprises a cooling module (26) in which at least the refrigeration machine (8) and an electronic controller is arranged.

8. The system for cooling a computing system as claimed in the preceding claim, **characterized in that** the feed flow temperature of the first cooling circuit (21) differs from the feed flow temperature of the second cooling circuit (22) by at least 20 °C, preferably by at least 30 °C.

9. The system for cooling a computing system as claimed in any of the preceding claims, **characterized in that** a heat exchanger of the first cooling circuit and/or a heat exchanger connected to the hot section of the refrigeration machine is connected to the heating system of a building, to a hot water supply, and/or to a power generator.

10. The system for cooling a computing system as claimed in any of the preceding claims, **characterized in that** the refrigeration machine is integrated into a rack (20) and/or into a server, in particular a blade server, and/or into other components (power supplies, telecommunications) or is arranged directly adjacent to a server or a rack.

11. The system for cooling a computing system as claimed in any of the preceding claims, wherein a liquid of the second cooling circuit after having passed through a cold section of the refrigeration machine (8) can be passed via a heat exchanger for cooling the air prevailing in the computing system, and wherein the liquid after having passed through the heat exchanger is suppliable to the first cooling circuit.

12. The system for cooling a computing system as claimed in any of the preceding claims, **characterized in that** the computing system and the refrigeration machine (8) are arranged in the same room, in particular the refrigeration machine (8) is integrated into a component of the computing system or is arranged adjacent to a component of the computing system, and wherein there is no air conditioning provided to cool the air in the room.

13. The system for cooling a computing system as claimed in any of the preceding claims, **characterized in that** the system includes means for emergency shutdown in the event of a loss of coolant.

14. A method for cooling a computing system, wherein the computing system comprises at least a first cooling circuit (21) and a second cooling circuit (22); wherein the first cooling circuit (21) is operated at a higher temperature than the second cooling circuit (22) and using a liquid, and wherein by means of the first cooling circuit (21) heat is discharged to the outside or is reused as useful heat for heating purposes and hot water;
wherein at least the second cooling circuit (22) is operated through a cold section of a refrigeration machine (8) which is used to produce cold, that means a temperature that is lower than the ambient temperature; wherein the first cooling circuit is used to cool processors and/or power components arranged in a housing by means of the liquid;
and wherein the air in the housing is cooled by a heat exchanger (24) arranged in or at the housing, which heat exchanger is connected to the second cooling circuit (22).

15. The method for cooling a computing system as claimed in the preceding claim, **characterized in that** a return flow of the first cooling circuit (3) is temporarily connected both to a heat exchanger and to the cold section of the refrigeration machine (8), in particular by means of a directional valve.

## Revendications

1. Système de refroidissement d'une installation de calcul (1), comprenant une machine frigorifique (8) servant à la production de froid, donc d'une température inférieure à la température ambiante,
l'installation de calcul comprenant un premier circuit de refroidissement (21) au moyen duquel des processeurs et/ou des composants de puissance de l'installation de calcul (1) disposés dans un boîtier peuvent être refroidis par un liquide,
le premier circuit de refroidissement étant relié à un échangeur de chaleur (23), de la chaleur étant, au moyen du premier circuit de refroidissement (21), dissipée vers l'extérieur ou continuant à être exploitée comme chaleur utile pour le chauffage et l'eau chaude,
et l'installation de calcul (1) comprenant un deuxième circuit de refroidissement (22) relié à une partie froide de la machine frigorifique (8) et comprenant un échangeur de chaleur (24) disposé dans le boîtier, lequel est raccordé au deuxième circuit de refroidissement (22) et est refroidi par l'air à l'intérieur du boîtier, et le deuxième circuit de refroidissement (22) étant mis en service à une température aller inférieure à celle du premier circuit de refroidissement (21).

2. Système de refroidissement d'une installation de calcul selon la revendication précédente, le système étant **caractérisé en ce qu'**il comprend au moins trois circuits de refroidissement (21, 22, 38), dont l'un fonctionne avec de l'air et les deux autres avec un liquide, au moins un circuit de refroidissement des autres circuits de refroidissement pouvant être relié à un échangeur de chaleur (23) externe ainsi qu'à une partie froide de la machine frigorifique (8).

3. Système de refroidissement d'une machine frigorifique selon l'une des revendications précédentes, **caractérisé en ce que** le premier circuit de refroidissement (21) ainsi que la partie chaude de la machine frigorifique (8) comprennent chacun un échangeur de chaleur, les deux étant thermiquement raccordés par l'intermédiaire d'un autre échangeur de chaleur, et la chaleur perdue des deux circuits de refroidissement pouvant être dissipée en commun.

4. Système de refroidissement d'une installation de calcul selon l'une des revendications précédentes, **caractérisé en ce que** la machine frigorifique (8) est une machine frigorifique à compression ou une machine frigorifique à sorption, en particulier une machine frigorifique à adsorption, à absorption et/ou fonctionnant suivant le principe de séchage par absorption (DCS), une machine frigorifique fonctionnant par effet thermoélectrique et/ou une machine frigorifique fonctionnant suivant le principe magnétocalorique et/ou une machine frigorifique géothermique et/ou une machine frigorifique fonctionnant avec des éléments Peltier et/ou une machine frigorifique à jet de vapeur et/ou une machine frigorifique fonctionnant par effet Joule-Thomson et/ou une machine frigorifique fonctionnant suivant le principe de refroidissement par évaporation.

5. Système de refroidissement d'une installation de calcul selon l'une des revendications précédentes, le système étant **caractérisé en ce qu'**il comprend un moyen de distribution variable du fluide de refroidissement à l'intérieur de l'installation de calcul.

6. Système de refroidissement d'une installation de calcul selon l'une des revendications précédentes, le système étant **caractérisé en ce qu'**il comprend une électronique de régulation avec une interface pour le raccordement de l'installation de calcul.

7. Système de refroidissement d'une installation de calcul selon l'une des revendications précédentes, le système étant **caractérisé en ce qu'**il comprend un module de refroidissement (26) où sont disposées au moins la machine frigorifique (8) et une commande électronique.

8. Système de refroidissement d'une installation de calcul selon la revendication précédente, **caractérisé en ce que** la température aller du premier circuit de refroidissement (21) se différencie d'au moins 20°C, préférentiellement d'au moins 30°C, de la température aller du deuxième circuit de refroidissement (22).

9. Système de refroidissement d'une installation de calcul selon l'une des revendications précédentes, **caractérisé en ce qu'**un échangeur de chaleur du premier circuit de refroidissement et/ou un échangeur de chaleur relié à une partie chaude de la machine frigorifique sont raccordés au système de chauffage d'un immeuble, à une alimentation en eau chaude et/ou à un générateur de courant.

10. Système de refroidissement d'une installation de calcul selon l'une des revendications précédentes, **caractérisé en ce que** la machine frigorifique est intégrée à un rack (20) et/ou un serveur, en particulier un serveur lame, et/ou à d'autres composants (alimentation en courant, télécommunication), ou est directement adjacente à un serveur ou à un rack.

11. Système de refroidissement d'une installation de calcul selon l'une des revendications précédentes, dans lequel un liquide du deuxième circuit de refroidissement peut être conduit vers la machine frigorifique (8) par l'intermédiaire d'un échangeur de chaleur après traversée d'une partie froide pour refroidissement de l'air présent dans l'installation de calcul, et dans lequel le liquide peut être conduit vers le premier circuit de refroidissement après traversée de l'échangeur de chaleur.

12. Système de refroidissement d'une installation de calcul selon l'une des revendications précédentes, **caractérisé en ce que** l'installation de calcul et la machine frigorifique (8) sont disposées dans un même compartiment, en particulier **en ce que** la machine frigorifique (8) est intégrée à un composant de l'installation de calcul ou est adjacente à un composant de l'installation de calcul, et dans lequel aucune installation de climatisation n'est présente pour le refroidissement de l'air ambiant.

13. Système de refroidissement d'une installation de calcul selon l'une des revendications précédentes, le système étant **caractérisé en ce qu'**il comporte un moyen d'arrêt d'urgence en cas d'une fuite d'agent réfrigérant.

14. Procédé de refroidissement d'une installation de calcul, ladite installation de calcul comprenant au moins un premier circuit de refroidissement (21) et un deuxième circuit de refroidissement (22), le premier circuit de refroidissement (21) étant mis en service à une température supérieure à celle du deuxième circuit de refroidissement (22) et avec un liquide, de la chaleur étant, au moyen du premier circuit de refroidissement (21), dissipée vers l'extérieur ou continuant à être exploitée comme chaleur utile pour le chauffage et l'eau chaude,
au moins le deuxième circuit de refroidissement (22) étant mis en service par l'intermédiaire d'une partie froide d'une machine frigorifique (8) servant à la production de froid, donc d'une température inférieure à la température ambiante,
au moyen du premier circuit de refroidissement, des processeurs et/ou des composants de puissance disposés dans un boîtier pouvant être refroidis par le liquide,
et l'air à l'intérieur du boîtier étant refroidi par l'intermédiaire d'un échangeur de chaleur (24) disposé dans le boîtier, lequel est raccordé au deuxième circuit de refroidissement (22).

15. Procédé de refroidissement d'une installation de calcul selon la revendication précédente, **caractérisé en ce qu'**un retour du premier circuit de refroidissement (3) est temporairement relié à un échangeur de chaleur ainsi qu'à la partie froide de la machine frigorifique (8), en particulier par l'intermédiaire d'un distributeur.
